(19) Europäisches Patentamt
European Patent Office
Office européen des brevets

(11) Veröffentlichungsnummer: **0 265 637 B1**

(12) **EUROPÄISCHE PATENTSCHRIFT**

(45) Veröffentlichungstag der Patentschrift: **31.03.93**

(51) Int. Cl.5: **H04L 25/49**, H03K 4/02, H04B 3/23, H03M 1/74, G06F 1/02

(21) Anmeldenummer: **87113056.3**

(22) Anmeldetag: **07.09.87**

(54) **Impulsformer.**

(30) Priorität: **26.09.86 DE 3632798**
**30.04.87 DE 3714527**
**07.07.87 DE 3722461**
**07.07.87 DE 3722463**

(43) Veröffentlichungstag der Anmeldung:
**04.05.88 Patentblatt 88/18**

(45) Bekanntmachung des Hinweises auf die Patenterteilung:
**31.03.93 Patentblatt 93/13**

(84) Benannte Vertragsstaaten:
**AT BE CH DE FR GB IT LI LU NL SE**

(56) Entgegenhaltungen:

**IEEE JOURNAL OF SOLID-STATE CIRCUITS, Band SC-19, Nr. 6, Dezember 1984, Seiten 861-869, IEEE, New York, US; C.A. LABER et al.: "A monolithic 1200 Baud FSK CMOS modem"**

(73) Patentinhaber: **SIEMENS AKTIENGESELLSCHAFT**
**Wittelsbacherplatz 2**
**W-8000 München 2(DE)**

(72) Erfinder: **Rössler, Bernward, Dipl.-Ing.**
**Franz-Reber-Weg 6**
**W-8000 München 71(DE)**
Erfinder: **Wolter, Eberhard, Dipl.-Ing.**
**Altomünsterstrasse 31**
**W-8000 München 50(DE)**

**EP 0 265 637 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

IEEE TRANSACTIONS ON COMMUNICATION TECHNOLOGY, Band COM-16, Nr. 1, Februar 1968, Seiten 81-93, IEEE, New York, US; H.B. VOELCKER: "Generation of digital signaling waveforms"

PROCEEDINGS 1982 INTERNATIONAL SYMPOSIUM ON SUBSCRIBER LOOPS AND SERVICES, Toronto, 20.-24. September 1982, Seiten 201-205, IEEE, New York, US; O. AGAZZI et al.: "Large scale integration of hybrid-method digital subscriber loops"

PROCEEDINGS OF THE IEEE 1987 CUSTOM INTEGRATED CIRCUITS CONFERENCE, Portland, Oregon, 4.-7. Mai 1987, Seiten 457-460, IEEE, New York, US; B. ROESSLER et al.: "CMOS analog front end of a transceiver with digital echo cancellation for ISDN"

## Beschreibung

Die Erfindung betrifft einen Impulsformer für die Umformung von mehrpegeligen, zu einer Eingangssignalfolge gehörenden Eingangs-Digitalsignalen mit sprunghaften Pegelübergängen in treppenförmige Pegelübergänge aufweisende Ausgangs-Digitalsignale, welche durch eine lineare Überlagerung eine der Eingangssignalfolge entsprechende Ausgangssignalfolge bilden, mit einem eine Vielzahl von Ausgängen aufweisenden Steuersignalgeber, welcher auf das Auftreten eines Eingangs-Digitalsignals hin an seinen Ausgängen nacheinander Steuersignale in äquidistanten zeitlichen Abständen abgibt, die in ihrer Gesamtheit die Dauer eines Ausgangs-Digitalsignals festlegen, und mit einem zumindest an einem Teil der Ausgänge des Steuersignalgebers angeschlossenen Summiernetzwerk, welches zu durch das Auftreten von Steuersignalen an dem mit ihm verbundenen Ausgängen des Steuersignalgebers festgelegten Zeitintervallen jeweils ein dem jeweiligen Ausgang zugeordnetes, einer festgelegten Stufe des zu bildenden Ausgangs-Digitalsignals entsprechendes Teilsignal bereitstellt und die zeitlich nacheinander auftretenden Teilsignale zu dem genannten treppenförmigen Ausgangs-Digitalsignal aufsummiert.

Derartige Impulsformer werden beispielsweise in Datenübertragungseinrichtungen für eine Duplexübertragung von Digitalsignalen im Gleichlageverfahren über eine Zweidraht-Leitung eingesetzt. Für eine solche Duplexübertragung sind die als Sendesignale abzugebenden Digitalsignale, beispielsweise dreipeglige und vierpegelige Digitalsignale (Ternärsignale oder Quarternärsignale) mit Hilfe eines Impulsformers in Signale mit einem analogen Verlauf umzuwandeln, häufig in Signale mit einem $\sin^2$-Verlauf. Neben einem Impulsformer ist in derartigen Datenübertragungseinrichtungen ein Echokompensator vorgesehen, der die durch Abgabe von Sendesignalen zusammen mit Empfangssignalen auftretenden Echosignale kompensiert. Sollen beispielsweise bei der Übertragung von dreipegeligen Digitalsignalen (+3, 0, -1) oder vierpegeligen Digitalsignalen (+1, -1, +3, -3) in dem betreffenden Echokompensator die den positiven und negativen Digitalsignalen entsprechenden Echosignale abgesehen vom Vorzeichen mit den gleichen Koeffizienten kompensiert werden, so müssen die von dem Impulsformer abgegebenen umgeformten, einander entsprechenden positiven und negativen Digitalsignale gleiche Amplitude und Form aufweisen.

Ein Impulsformer der eingangs genannten Art ist bereits bekannt. (IEEE Transactions on Communication Technology, Febr. 1968, Vol. COM-16, No. 1, Seiten 81 bis 93). Bei diesem bekannten Impulsformer ist mit einem Schieberegister, welches von den umzuformenden Digitalsignalen durchlaufen wird, als Summiernetzwerk eine Widerstandsanordnung verbunden. Über diese Widerstandsanordnung erhält ein Summierschaltkreis nach Maßgabe des jeweils gerade das Schieberegister durchlaufenden Digitalsignals Teilströme zugeführt, welche am Ausgang des Summierschaltkreises ein treppenförmiges Ausgangssignal hervorrufen. Der Nachteil eines solchen Impulsumformers besteht darin, daß nur treppenförmige Ausgangssignale einer Polarität erzeugbar sind, d.h. er ist lediglich für die Bildung von einen treppenförmigen Verlauf aufweisenden Binärsignalen geeignet. Nicht geeignet ist er dagegen für die Bildung von beispielsweise dreipegeligen oder vierpegeligen Digitalsignalen (Ternär- oder Quarternärsignale), welche wenigstens zwei zu einem Referenzwert symmetrisch liegende Werte annehmen können. Darüber hinaus ist es durch die feste Anschaltung der Widerstände an das Schieberegister nicht möglich, die Widerstände für die Bildung der ansteigenden und abfallenden treppenförmigen Flanken eines Ausgangssignals mehrfach zu benutzen. Dadurch ist es erforderlich, auch bei gleichen ansteigenden und abfallenden treppenförmigen Flanken eine der Summe sämtlicher Stufen entsprechende Anzahl von Widerständen zu verwenden.

Darüber hinaus ist es bereits im Zusammenhang mit einem FSK-Modem bekannt (IEEE Journal of Solid-State Circuits, Vol. SC-19, No. 6,Dez. 1984, Seiten 861-869), zur Erzeugung von Sinusschwingungen eine Kondensatoranordnung zu verwenden. Diese Kondensatoranordnung besteht aus vier Kondensatoren, die über Schalter ansteuerbar sind und zu fest vorgegebenen Zeitpunkten Teilspannungen nacheinander bereitstellen. Diese Teilspannungen werden von einem diesen Kondensatoren nachgeschalteten weiteren Kondensator aufsummiert.

Es ist nun Aufgabe der vorliegenden Erfindung, einen Weg zu zeigen, wie ein Impulsformer der eingangs genannten Art ausgebildet werden kann, um beliebige mehrpegelige Ausgangs-Digitalsignale mit treppenförmigen Übergängen zu bilden.

Gelöst wird die vorstehend aufgezeigte Aufgabe bei einer Schaltungsanordnung der eingangs genannten Art durch die im Patentanspruch 1 angegebenen kennzeichnenden Merkmale.

Der Vorteil des Impulsformers gemäß der vorliegenden Erfindung besteht darin, daß die Umladekondensatoren über die mit ihnen jeweils verbundene Schalteranordnung zu beliebigen Zeitpunkten in die Bildung von treppenförmigen Ausgangs-Digitalsignalen einbezogen werden können. Auf diese Weise ist es beispielsweise für die Bildung von treppenförmigen Ausgangs-Digitalsignalen mit jeweils gleichen ansteigendem und abfallendem Flankenverlauf lediglich erforderlich, eine der in einer der Flanken vorhandenen Stufen entsprechende Anzahl von Umladekondensatoren zu verwenden. Darüber hinaus ist es möglich, unter Verwendung der Umladekondensatoren mehrpegelige Ausgangs-Digitalsignale, z. B. Ternärsignale oder Quarternärsignale zu bilden, deren mögliche Pegel symmetrisch zu einem vorgegebenen Referenzwert liegen. Da auch hierbei stets dieselben Umladekondensatoren benutzt sind, ist sichergestellt, daß für die einander entsprechenden, symmetrisch zu dem Referenzwert liegenden Pegel abgesehen vom Vorzeichen die Form und die Amplitude der Ausgangs-Digitalsignale gleich sind.

Vorteilhafte Ausgestaltungen des Impulsformers gemäß der Erfindung ergeben sich aus den Unteransprüchen. Insbesondere weisen diese Unteransprüche vorteilhafte Ausgestaltungen des Impulsformers für die Bildung von vierstufigen Ausgangs-Digitalsignalen auf, welche zwei erste, zu einem Referenzwert symmetrisch liegende und zwei zweite, ebenfalls symmetrisch zu dem Referenzwert liegende und von den ersten Werten um einen festgelegten ganzzahligen Faktor sich unterscheidende Werte annehmen können. Der Vorteil dieser Ausgestaltungen besteht darin, daß mit einem geringen zusätzlichen schaltungstechnischen Aufwand sichergestellt ist, daß die Anforderung nach Gleichheit in Form und Amplitude für einander entsprechende Werte der Ausgangs-Digitalsignaleund nach dem festgelegten Faktor entsprechenden Amplitudenverhältnissen für sich unterscheidende Werte in für die Praxis ausreichender Genauigkeit erfüllt ist.

Im folgenden wird die Erfindung anhand von Zeichnungen beispielsweise näher beschrieben.

FIG 1 zeigt eine Datenübertragungseinrichtung mit einem Impulsformer gemäß der vorliegenden Erfindung,

FIG 2 zeigt den Aufbau des in FIG 1 angegebenen Impulsformers,

FIG 3a bis 3c zeigen auf den Impulsformer gemäß FIG 2 sich beziehende Diagramme,

FIG 4 zeigt die Beschaltung des in FIG 2 schematisch dargestellten Operationsverstärkers für eine Offsetkompensation,

FIG 5 zeigt des Aufbau des in FIG 2 dargestellten Operationsverstärkers,

FIG 6 zeigt eine erste Ausgestaltung des in FIG 2 dargestellten Impulsformers,

FIG 7 und 8 zeigen auf den Impulsformer gemäß FIG 6 sich beziehende Diagramme,

FIG 9 zeigt eine zweite Ausgestaltung des in FIG 2 dargestellten Impulsformers,

FIG 10 und 11 zeigen auf den Impulsformer gemäß FIG 9 sich beziehende Diagramme,

FIG 12 zeigt eine dritte Ausgestaltung des in FIG 2 dargestellten Impulsformers,

FIG 13 und 14 zeigen auf den Impulsformer gemäß FIG 12 sich beziehende Diagramme und

FIG 15 zeigt ausschnittweise ein Ausführungsbeispiel für die Ansteuerung der in FIG 2 dargestellten Schalteranordnung.

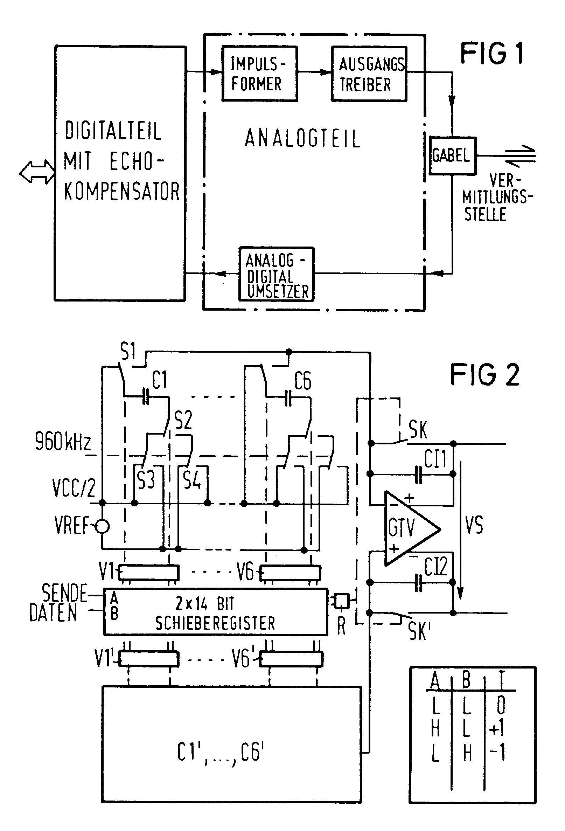

In FIG 1 ist eine Datenübertragungseinrichtung für eine Duplexübertragung von Digitalsignalen im Gleichlageverfahren über eine Zweidraht-Leitung dargestellt. Über diese Zweidraht-Leitung möge die Datenübertragungseinrichtung beispielsweise an Übertragungseinrichtungen einer Vermittlungsstelle angeschlossen sein. Andererseits ist die Datenübertragungseinrichtung über eine Vierdraht-Leitung mit einem Datenendgerät verbunden. Die Datenübertragungseinrichtung ist dabei aus einem Digitalteil und einen Analogteil gebildet. Der Digitalteil möge dabei von dem Datenendgerät her für eine Übertragung über die Zweidraht-Leitung abgegebene Binärsignale aufnehmen und diese in mehrpegelige Signale umsetzen. Derartige mehrpegelige Signale können beispielsweise nach einem AMI-Code, nach einem 4B-3T-Block-Code (Ternärsignale) oder nach einem 2B1Q-Code (Quarternärsignale) codiert sein. Nach einer solchen Codeumsetzung leitet dann der Digitalteil die umgesetzten Signale an einen zu dem Analogteil der Datenübertragungseinrichtung gehörenden Impulsformer weiter. Eine weitere Möglichkeit besteht darin, daß der Digitalteil lediglich Informationen bezüglich der zu bildenden mehrpegeligen Digitalsignale in binär codierter Form dem Impulsformer zuführt. Dieser Impulsformer wandelt, wie im folgenden noch erläutert werden wird, die ihm zugeführten Signale in mehrpegelige Signale mit annähernd analogen Verlauf um und leitet diese anschließend an einen Ausgangstreiber weiter. Dieser Ausgangstreiber nimmt eine Leistungsverstärkung der von dem Impulsformer umgeformten Signale vor. Die am Ausgang dieses Ausgangstreibers auftretenden leistungsverstärkten Signale gelangen schließlich über eine Gabelschaltung als Sendesignale auf die genannte Zweidraht-Leitung.

Als Empfangssignale auf der genannten Zweidraht-Leitung auftretende Signale werden über die Gabelschaltung aufgenommen und einem Analog-Digital-Umsetzer zugeführt. Dabei gibt die Gabelschaltung zusätzlich zu den Empfangssignalen an den Analog-Digital-Umsetzer noch als Echosignale bezeichnete Störsignale ab, welche bei der Abgabe von Sendesignalen entweder direkt in der Gabelschaltung durch eine nicht vollständige Entkopplung der Übertragungswege oder an Reflektionsstellen der Zweidraht-Leitung entstehen. Damit erhält der Analog-Digital-Umsetzer nicht nur die tatsächlichen Empfangssignale sondern ein aus diesen und den Echosignalen gebildetes Signalgemisch zugeführt.

Das am Ausgang des Analog-Digital-Umsetzers in digitaler Form auftretende Signalgemisch übernimmt der Digitalteil der in FIG 1 dargestellten Datenübertragungseinrichtung. Dieser Digitalteil weist einen Echokompensator auf, der die von dem Analog-Digital-Umsetzer in digitaler Form abgegebenen Empfangssignale von den mit diesen zusammen auftretenden Echosignalen befreit. Die von Echosignalen befreiten Empfangssignale, die wieder als mehrpegelige Signale auftreten, werden anschließend in dem Digitalteil in binäre Signale umcodiert und über die Vierdraht-Leitung dem genannten Datenendgerät zugeführt.

Im folgendenden wird lediglich näher auf den Impulsformer der in FIG 1 dargestellten Datenübertragungseinrichtung eingegangen. Dabei wird zunächst eine Ausführungsform für den Impulsformer beschrieben, welche z. B. für die Bildung von dreipegeligen Digitalsignalen (Ternärsignalen) geeignet ist. Die übrigen in FIG 1 dargestellten Einrichtungen sind bereits hinlänglich bekannt, so daß sich eine Beschreibung der Wirkungsweise dieser Einrichtungen erübrigt.

Eher auf den Aufbau des Impulsformers näher eingegangen wird, werden zunächst einige Forderungen dargelegt, die von dem Impulsformer zu erfüllen sind. Wie bereits zuvor erwähnt, mögen die von dem Endgerät abgegebenen Binärsignale für eine Übertragung über die Zweidraht-Leitung in dreipegelige Signale umgesetzt werden. Derartige dreipegelige Signale weisen Sendeimpulse mit einem logischen Pegel +1, 0 und -1 auf. Um im Echokompensator für +1- und -1-Sendeimpulse, abgesehen vom Vorzeichen, die gleichen Koiffizienten verwenden zu können, müssen Amplitude und Form der von dem Impulsformer umgeformten +1-und -1 Sendeimpulse möglichst genau übereinstimmen. Zur Erfüllung von Störstrahlungsanforderungen in Leitungsbündeln ist im allgemeinen für +1- und -1-Sendeimpulse eine $\sin^2$-Form vorgeschrieben. Diese $\sin^2$-förmigen Sendeimpulse sind um einen Faktor 13/8 länger als die Schrittweite der von dem Datenendgerät abgegebenen Binärsignale, so daß sich z. B. bei einer Übertragung einer Datenfolge +1, +1, -1, -1 oder +1, -1 jeweils zwei Sendeimpulse überlagern. Die Überlagerung dieser Sendeimpulse muß im Impulsformer streng linear erfolgen, damit die Echokompensation für jeden Sendeimpuls des dreipegeligen Signals getrennt durchgeführt werden kann.

In FIG 2 ist der Aufbau des vorerwähnten Impulsformers näher dargestellt. Dieser Impulsformer nähert die für Sendeimpulse vorgesehene $\sin^2$-Form durch einen treppenförmigen Verlauf an. Die einzelnen Sendeimpulse, die mit einer Übertragungsgeschwindigkeit von 120 kHz auftreten mögen, weisen dabei jeweils 13 960-kHz-Perioden auf. Die Impulsformung erfolgt durch Ladungsumverteilung zwischen geschalteten, in FIG 2 mit C1 bis C6 bezeichneten Umladekondensatoren und einem Summierkondensator CI1, der zwischen einem "-"-Eingang und einem "+"-Ausgang eines Gegentaktoperationsverstärkers GTV liegt. Jeder dieser Umladekondensatoren ist mit einer jeweils vier Umschalter S1 bis S4 aufweisenden Schalteranordnung verbunden. Sämtliche Umladekondensatoren sind dabei in der gleichen Weise mit der ihnen zugehörigen Schalteranordnung verbunden. In FIG 2 ist die Anschaltung des Umladekondensators C1 an die zugehörige Schalteranordnung dargestellt. Der Umschalter S1 verbindet einen der Anschlüsse des Umladekondensators C1 wahlweise mit dem an den "-"-Eingang des Operationsverstärkers GTV angeschlossenen Anschluß des Summierkondensators CI1 oder mit einer Spannung VCC/2 (z. B. OV) Der Umschalter S2 ist an den anderen Anschluß des Umladekondensators C1 angeschlossen und steht über die Umschalter S3 und S4 wahlweise mit VCC/2 oder mit einer Bezugsspannungsquelle VREF in Verbindung. Die Umschalter S3 und S4 erhalten dabei für ihre Steuerung Taktsignale mit einer Taktfrequenz von 960 kHz zugeführt. Die beiden Umschalter S1 und S2 sind dagegen über eine Verknüpfungsschaltung V1 an festgelegte Registerzellen einer Schieberegisteranordnung angeschlossen. In entsprechender Weise sind auch die übrigen Umladekondensatoren C2 bis C6, wie für den Umladekondensator C6 angedeutet, jeweils mit der ihnen zugeordneten Schalteranordnung verbunden. Die dem Umladekondensator C6 zugeordnete Verknüpfungsschaltung ist dabei in FIG 2 mit V6 bezeichnet.

Die zuvor genannte Schieberegisteranordnung ist aus zwei 14-Bit-Schieberegistern A und B gebildet. Die dem Impulsformer mit einer Übertragungsgeschwindigkeit von 120 kHz zugeführten dreipegeligen Sendesignale werden binär codiert mit einer Flanke eines 120-kHz-Taktes in die beiden Schieberegister A und B übernommen. Die für die genannte Binärcodierung maßgebende Wahrheitstabelle ist in Figur 2 dargestellt. In Spalte T sind dabei die logischen Pegel +1, 0, -1 für die dreipegeligen Sendesignale dargestellt. In den Spalten A und B sind dagegen diesen logischen Pegeln entsprechende logische Pegel für die den Schieberegistern A und B zugeführten Binärsignale angegeben. Die gemäß der Wahrheitstabelle gebildeten Binärsignale durchlaufen die einzelnen Registerzellen der beiden Schieberegister mit einer Übertragungsgeschwindigkeit von 960 kHz. Die beiden Schieberegister erhalten dafür einen 960-kHz-Takt zugeführt. Mit vorgegebenen Registerzellen dieser beiden Schieberegister sind die den oben genannten Umladekondensatoren C1 und C6 zugehörigen Verknüpfungsschaltungen V1 bis V6 verbunden.

Mit den Schieberegistern A und B ist eine weitere, in Figur 2 mit R bezeichnete Verknüpfungsschaltung verbunden. Diese steuert einen Schalter SK, der auf eine entsprechende Ansteuerung hin den bereits genannten Summierkondensator CI1 kurzschließt.

Der in Figur 2 dargestellte Impulsformer weist neben den bereits genannten Umladekondensatoren C1 bis C6 weitere, nicht dargestellte Umladekondensatoren C1' bis C6' auf, die wie die Umladekondensatoren C1 bis C6 jeweils mit einer aus vier Umschaltern bestehenden Schalteranordnung verbunden sind. Diese Schalteranordnungen sind jeweils über eine Verknüpfungsschaltung, in Figur 2 mit V1' bis V6' bezeichnet, an festgelegte Registerzellen der beiden Schieberegisteranordnungen A und B angeschlossen. Die Umladekondensatoren C1' bis C6' entsprechen im übrigen den Umladekondensatoren C1 bis C6.

Darüber hinaus ist ein weiterer, über die zuletzt genannten Schalteranordnungen mit den Umladekondensatoren C1' bis C6' verbindbarer, dem Summierkondensator CI1 entsprechender Summierkondensator CI2 vorgesehen. Dieser Summierkondensator liegt zwischen einem "+"-Eingang und einem "-"-Ausgang des bereits genannten Gegentaktoperationsverstärkers GTV. Parallel zu diesem Summierkondensator ist ein Schalter SK' angeordnet. Dieser Schalter schließt den Summierkondensator CI2 auf eine Ansteuerung von der bereits genannten Verknüpfungsschaltung R hin kurz.

Im folgenden wird nun die Wirkungsweise des in Figur 2 dargestellten Impulsformers anhand der Umladekondensatoren C1 bis C6 und des Summierkondensators (CI1) erläutert. Wie bereits zuvor erwähnt, erhält der Impulsformer mit einer Übertragungsgeschwindigkeit von 120 kHz auftretende dreipegelige Sendeimpulse zugeführt, die gemäß der in Figur 2 dargestellten Wahrheitstabelle binär codiert sind. Abtastproben dieser binär codierten Signale werden mit Hilfe eines 120-kHz-Taktes in die beiden 14-Bit-Schieberegister A und B aufgenommen. Die einzelnen Abtastproben durchlaufen dann die Registerzellen der Schieberegister mit einer Übertragungsgeschwindigkeit von 960 kHz, so daß an den Ausgängen der Registerzellen nacheinander den Abtastproben entsprechende Signale auftreten. Durch das Auftreten dieser Signale werden 13 960-kHz-Perioden für jede Abtastprobe und damit für jeden Sendeimpuls festgelegt.

Entsprechend der genannten 13 Perioden werden die Sendeimpulse jeweils in ein 13 Perioden aufweisendes treppenförmiges Signal umgeformt. Ein solches treppenförmiges Signal weist angenähert einen $\sin^2$-Verlauf auf. Die Impulsformung erfogt dabei durch Ladungsumverteilung zwischen den Umladekondensatoren C1 bis C6 und dem Summierkondensator CI1. Entsprechend der Richtung des Umladestromes nimmt die Ausgangsspannung VS an dem "+"-Ausgang des Gegentaktoperationsverstärkers GTV zu oder ab. Beispielsweise kann der Umladekondensator C1 auf die Bezugsspannung VREF aufgeladen werden. Die Ladung wird dann an den Summierkondensator CI1 abgegeben. Dabei tritt am Ausgang des Operationsverstärkers GTV ein Spannungssprung dVS = C1/CI1.VREF auf. Wird dagegen der Umladekondensator C1 zuerst entladen und im nächsten Schritt mit einem seiner Anschlüsse mit dem Summierkondensator CI1 und mit dem anderen Anschluß mit der Bezugsspannungsquelle VREF verbunden, dann wird der Umladekondensator C1 durch den Summierkondensator aufgeladen, wobei sich am Ausgang des Operationsverstärkers GTV ein Spannungssprung von dVS = - C1/CI1.VREF einstellt. In entsprechender Weise können auch die übrigen Umladekondensatoren Ladung an den Summierkondensator CI1 abgeben bzw. Ladung von diesem aufnehmen.

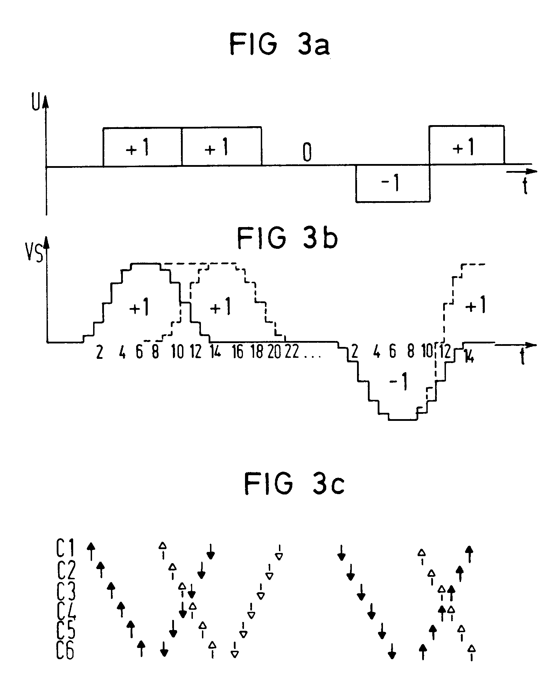

In Figur 3a ist eine von dem Impulsformer umzuformende Sendeimpulsfolge dargestellt. Als Beispiel ist eine Sendeimpulsfolge +1, +1, 0, - 1, + 1 angegeben. Das Diagramm 3b zeigt dagegen die dieser Sendeimpulsfolge entsprechende, am Ausgang des Operationsverstärkers GTV auftretende umgeformte Sendeimpulsfolge. Wie bereits oben erwähnt, sind die zu dieser Sendeimpulsfolge gehörenden Sendeimpulse um den Faktor 13/8 breiter als die dem Impulsformer zugeführten Sendeimpulse. Auf der Abszisse des Diagramms 3b sind dabei die zuvor genannten 960-kHz-Perioden aufgetragen, während auf der Ordinate die am Ausgang des Operationsverstärkers GTV auftretende Ausgangsspannung VS angegeben ist. In dem in Figur 3c dargestellten Pfeildiagramm ist die Reihenfolge angedeutet, in der die Umladekondensatoren C1 bis C6 bei der Sendeimpulsformung wirksam sind. Positive Spannungssprünge sind durch Pfeile nach oben und negative Spannungssprünge sind durch Pfeile nach unten symbolisch dargestellt. Die Größenverteilung der Umladekondensatoren C1 bis C6 ist durch die Anpassung der einzelnen Spannungsstufen an die $\sin^2$-Form festgelegt.

Bei der Erzeugung eines +1-Sendeimpulses wird in der ersten 960-kHz-Periode (binär codierte Abtastprobe des + 1-Sendeimpulses befindet sich in der ersten Registerzelle der Schieberegisteranordnung A und B) durch eine entsprechende Steuerung der mit dem Umladekondensator C1 verbundenen Schalteranordnung der Umladekondensator C1 auf VREF aufgeladen, die Ladung auf den Summierkondensator CI1 übertragen und der Umladekondensator C1 wieder freigeschaltet. Dadurch tritt am Ausgang des Operationsverstärkers GTV eine positive Veränderung der Ausgangsspannung VS auf. In der zweiten bis sechsten Periode (Abtastprobe durchläuft die Registerzellen 2 bis 6 der Schieberegisteranordnung) geschieht das gleiche mit den Umladekondensatoren C2 bis C6. In der sechsten Periode ist dann am Ausgang des Operationsverstärkers GTV der Maximalwert der Ausgangsspannung VS erreicht. Von der 9. bis 14. Periode wird der Umladekondensator C1 zunächst entladen. Anschließend wird er mit einem seiner Anschlüsse mit dem Summierkondensator CI1 und mit dem anderen Anschluß mit der Bezugsspannungsquelle VREF verbunden. Damit wird der Umladekondensator C1 durch den Summierkondensator aufgeladen und es erfolgt nun eine negative Veränderung der Ausgangsspannung an dem Operationsverstärker GTV. In den Perioden 10 bis 14 erfolgt das gleiche für die Umladekondensatoren C2 bis C6. Damit ist in die Erzeugung eines +1-Sendeimpulses jeder Umladekondensator zweimal zeitlich nacheinander einbezogen.

Bei der Erzeugung eines -1-Sendeimpulses wird in der ersten Periode der Umladekondensator C1 entladen und anschließend von dem Summierkondensator CI1 aufgeladen. In den nächsten Perioden erfolgt das gleiche für die Umladekondensatoren C2 bis C6. Gegenüber einem +1-Sendeimpuls sind Auf- bzw. Entladung des Summierkondensators CI1 vertauscht. Da bei + 1- und -1-Sendeimpulsen die gleiche Bezugsspannung VREF sowie die gleichen Umladekondensatoren verwendet werden, sind die Form und die Amplitude bei + 1- und - 1-Sendeimpulsen unabhängig von den Kapazitätsverhältnissen und bei einem offsetfreien Operationsverstärker GTV einander gleich.

Aus Figur 3b geht hervor, daß bei einer Sendeimpulsfolge + 1, + 1 und - 1, + 1 jeweils in der 9. bis 13. Periode eine Überlagerung erfolgt. In der 9. Periode erfolgt z.B. bei der Sendeimpulsfolge + 1, + 1 wie bei einem einzelnen Sendeimpuls eine Aufladung des Umladekondensators C6 von dem Summierkondensator CI1 her. Gleichzeitig wird aber von dem Umladekondensator C1 her Ladung auf den Summierkondensator CI1 übertragen. Da bei der Überlagerung von Sendeimpulen die gleichen Umladekondensatoren beteiligt sind wie bei einzelnen Sendeimpulsen ist die Überlagerung linear und unabhängig von Kapazitätstoleranzen.

Tritt bei einer Sendeimpulsfolge eine 0 (14. Periode bei einem einzelnen Sendeimpuls) oder ein Wechsel + 1, - 1 bzw -1, + 1 auf, so wird der Summierkondensator zur frühestmöglichsten Periode, in der die Ausgangsspannung am Operationsverstärker GTV nominell 0 ist, kurzgeschlossen, d.h. entladen. Der Schalter SK erhält dafür von der Verknüpfungsschaltung R ein entsprechendes Rücksetzsignal zugeführt. Durch das Entladen des Summierkondensators CI1 werden bis dahin aufgelaufene Summierungsfehler infolge einer endlichen Verstärkung oder einer Offsetspannung des Operationsverstärkers GTV beseitigt.

Vorstehend wurde anhand der in Figur 3 dargestellten Diagramme die Wirkungsweise des in Figur 2 dargestellten Impulsformers lediglich anhand der Umladekondensatoren C1 bis C6 und des Summierkondensators CI1 erläutert. In entsprechender Weise werden auch die Umladekondensatoren C1' bis C6' und der Summierkondensator CI2 in die Erzeugung von Sendeimpulsfolgen einbezogen. Dabei treten am "-"-Ausgang des Operationsverstärkers V1 gegenüber den Sendeimpulsen am "+"-Ausgang bezogen auf eine Referenzspannung (z.B. VCC/2) inverse Sendeimpulse auf.

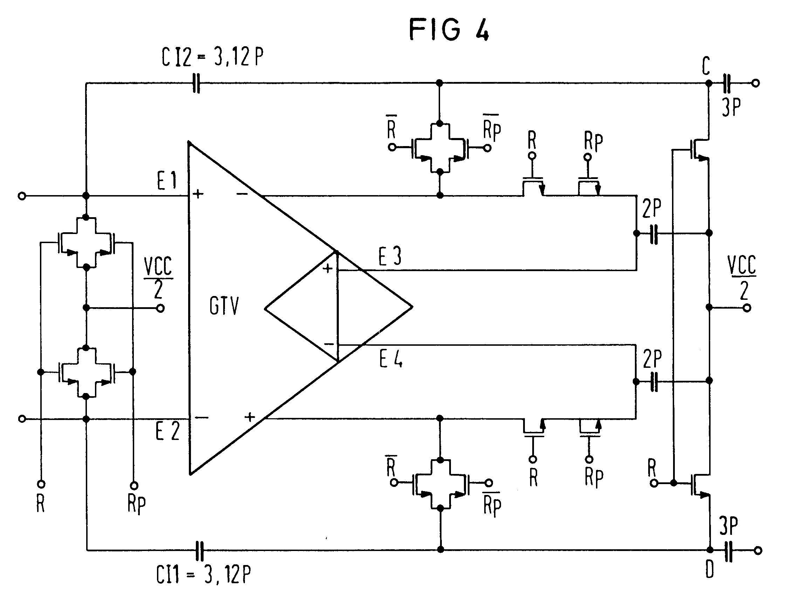

Für eine Minimierung von Nichtlinearitäten der Ausgangssignale, die sich auf die Form und die Amplitude der + 1- und - 1-Sendeimpulse auswirken, ist einerseits der Gegentaktoperationsverstärker GTV vorgesehen. Dieser Gegentaktoperationsverstärker bewirkt eine Verminderung der Störspannungseinkopplung und eine Verbesserung des Signal/Geräuschverhältnisses. Andererseits wird durch eine Kompensationsschaltung die Offsetspannung des Operationsverstärkers GTV reduziert. Diese Offsetkompensation, die während der Rücksetzphase des Impulsformers durchgeführt wird, vermindert gleichzeitig die 1/f-Transistorrauschbeiträge im Operationsverstärker GTV. Figur 4 zeigt die für eine Offsetkompensation vorgesehene Beschaltung des Operationsverstärkers.

Der Operationsverstärker GTV weist neben den in Figur 2 dargestellten Eingängen "+" und "-", die in Figur 4 mit E1 and E2 bezeichnet sind, zwei Hilfseingänge E3, E4 auf. In der Rücksetz-Phase, d.h. bei Abgabe eines Rücksetzsignales von der in Figur 2 dargestellten Verknüpfungsschaltung R her, ist der Hilfseingang E3 mit dem in Figur 2 dargestellten "-"-Ausgang des Operationsverstärkers GTV verbunden. In entsprechender Weise ist der Hilfseingang E4 in der Rücksetz-Phase mit dem "+"-Ausgang des Operationsverstärkers verbunden. Für diese Verbindungen werden jeweils zwischen den Hilfseingängen und den genannten Ausgängen des Operationsverstärkers liegende Transistoranordnungen auf das Auftreten eines Rücksetzsignals leitfähig gesteuert. Darüber hinaus ist mit den beiden Eingängen E1 und E2 des Operationsverstärkers GTV eine Reihenschaltung aus zwei Transistoranordnungen mit jeweils zwei parallelgeschalteten Transistoren verbunden. Der Verbindungspunkt zwischen den beiden Transistoranordnungen ist dabei an VCC/2 angeschlossen. Auf das Auftreten eines Rücksetzsignals hin sind die zu der Reihenschalten gehörenden Transistoren leitfähig gesteuert, so daß in der Rücksetz-Phase und damit bei der Offsetkompensation an den beiden Eingängen E1 und E2 die gleiche Spannung anliegt.

Die beiden bereits genannten Summierkondensatoren CI1 und CI2 sind jeweils über zwei parallelgeschaltete Transistoren mit einem Ausgang des Operationsverstärkers GTV verbunden, und zwar der Summierkondensator CI1 mit dem "+"-Ausgang und der Summierkondensator CI2 mit dem "-"-Ausgang. Die parallelgeschalteten Transistoren sind dabei während der Rücksetz-Phase gesperrt, so daß die Summierkondensatoren während der Offsetkompensation von den Ausgängen des Operationsverstärkers abgetrennt sind. Gleichzeitig werden die mit den parallelgeschalteten Transistoren verbundenen Anschlüsse der Summierkondensatoren über gesonderte Transistoren mit VCC/2 verbunden. Da während dieser Zeit auch die mit den Eingängen des Operationsverstärkers verbundenen Anschlüsse der Summierkondensatoren mit VCC/2 verbunden sind, erfolgt eine Entladung der beiden Summierkondensatoren.

Durch die während der Rücksetz-Phase durchgeführte Offset-Kompensation stellt sich ein Gleichgewichtszustand ein, der einer um den Faktor VH reduzierten Offsetspannung der Eingänge E1 und E2 entspricht. Die Verstärkung VH der Hilfseingänge E3 und E4 zum Verstärkerausgang beträgt etwa VH = 100. Die Steuerspannung an den Hilfseingängen wird in zwei Kondensatoren (2P) gespeichert und ist daher auch während der Sendeimpulsformung wirksam.

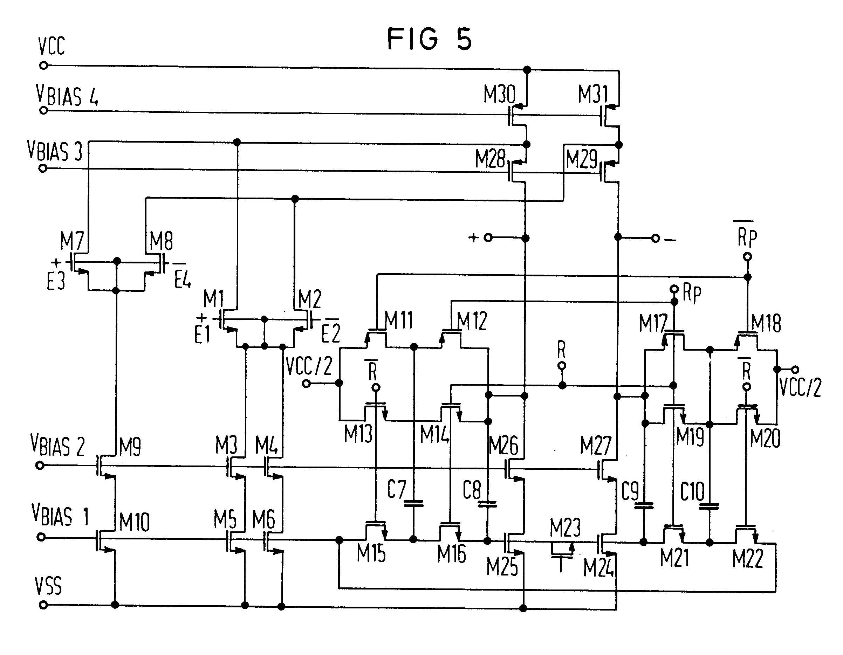

In Figur 5 ist der Aufbau des Operationsverstärkers GTV dargestellt.Dieser Operationsverstärker weist zwei parallelgeschaltete Strompfade auf, die jeweils eine Reihenschaltung aus 4 Stromquellen in Form von Transistoren darstellen. Die zu den Reihenschaltungen gehörenden Transistoren sind in Figur 5 mit M25, M26, M28 und M30 bzw. M24, M27, M29 und M31 bezeichnet. Der Verbindungspunkt zwischen den Transistoren M26 und M28 bildet dabei den "+"-Ausgang und der Verbindungspunkt zwischen den Transistoren M27 und M29 den "-"-Ausgang des Operationsverstärkers GTV.

Der Operationsverstärker weist außerdem zwei parallelgeschaltete Differenz-Eingangstransistoranordnungen auf. Jede dieser Anordnungen besteht aus einer Differenz-Transistorstufe M1, M2 bzw. M7, M8, die in Reihe mit einer Stromquellenanordnung geschaltet ist. Bei der mit der Differenz-Transistorstufe M1, M2 in Reihe geschalteten Stromquellenanordnung handelt es sich um eine Parallelschaltung von jeweils zwei in Reihe geschalteten Transistoren. Die in Reihe geschalteten Transistoren sind mit M3 und M5 bzw. M4 und M6 bezeichnet. Bei der mit der Differenz-Transistorstufe M7, M8 verbundenen Stromquellenanordnung handelt es sich dagegen um eine Reihenschaltung aus den Transistoren M9 und M10.

Die Eingänge der Differenz-Transistoranordnungen stellen die Eingänge E1 und E2 sowie die Hilfseingänge E3 und E4 des Operationsverstärkers GTV dar. Dabei der Eingang des Transistors M1 den Eingang E1, der Eingang des Transistors M2 den Eingang E2, der Eingang des Transistors M7 den Eingang E3 und der Eingang des Transistors M8 den Eingang E4.

Die Ausgänge der Transistoren M1 und M7 sind gemeinsam an den Verbindungspunkt zwischen den bereits genannten Transistoren M28 und M30 angeschlossen. Dagegen sind die Ausgänge der Transistoren M2 und M8 mit den Verbindungspunkt zwischen den Transistoren M29 und M31 verbunden.

Die vorstehend genannten Transistoren M1 bis M10 und M24 bis M31 bilden einen "Folded-Cascode"-Verstärker. Die Transistoren M24 bis M31 stellen dabei Lastwiderstände für die zuvor genannten Differenz-Transistoranordnungen dar.

Der in Figur 5 dargestellte Operationsverstärker weist darüber hinaus eine Gleichtakt-Gegenkopplungsanordnung dar, die aus Transistoren M11 bis M23 sowie aus den Kondensatoren C7 bis C10 gebildet ist. Über die Transistoren M11 bis M16 sowie über die Kondensatoren C7 und C8 steht dabei der Eingang des Transistors M25 mit dem "+"-Ausgang des Operationsverstärkers in Verbindung. Dagegen verbinden die Transistoren M17 bis M22 sowie die Kondensatoren C9 und C10 den Eingang des Transistors M24 mit dem "-"-Ausgang des Operationsverstärkers. Die strombestimmenden Transistoren M24 und M25 der Cascode-Stromquellen sind somit einerseits Bestandteil der Cascode-Stromquellen, die die Lastwiderstände der Differenz-Transistoranordnungen darstellen und andererseits Bestandteil der genannten Gleichtakt-Gegenkopplungsanordnung.

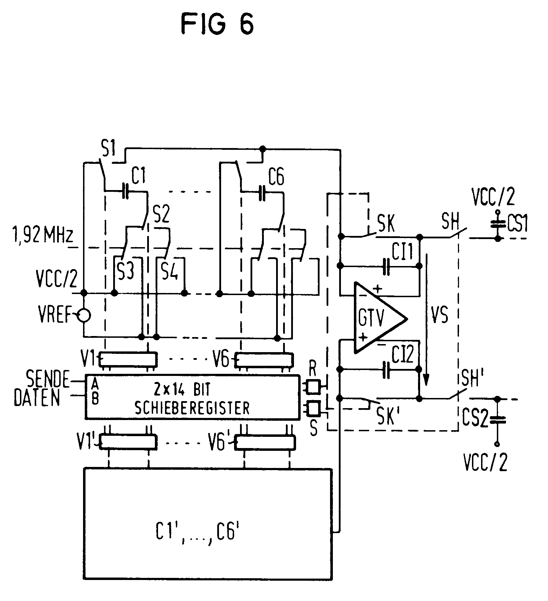

In den Figuren 6, 9 und 12 ist jeweils eine Weiterbildung des Impulsformers gemäß Figur 2 dargestellt. Mit diesen Weiterbildungen werden vierpegelige Ausgangs-Digitalsignale mit treppenförmigen Pegelübergängen gebildet. Derartige vierpegelige Digitalsignale mögen beispieslweise nach einem sogenannten "2B1Q"-Code (+3, +1, -1, -3) codiert sein. Um auch bei dieser Codierung den Aufwand für die obenangegebene Echokompensation möglichst gering zu halten, ist es zweckmäßig, in dem Echokompensator für +1, -1-Sendeimpulse abgesehen vom Vorzeichen den gleichen Koeffizienten zu verwenden und diesen Koeffizienten für +3, -3-Sendeimpulse mit dem Faktor 3 zu multiplizieren. Eine derartige Vorgehensweise ist möglich, wenn vom Vorzeichen abgesehen Form und Amplitude der Sendeimpulse +1, -1 bzw. +3, -3 gleich sind und die Amplituden von +3 bzw. -3-Sendeimpulsen und +1 bzw. -1-Sendeimpulsen sich um den Faktor 3 unterscheiden. Diese Anforderungen werden durch die genannten Weiterbildungen erfüllt.

Bei den genannten Weiterbildungen wird beispielsweise davon ausgeangen, daß dem jeweiligen Impulsformer Informationen bezüglich der zu bildenden vierpegeligen Digitalsignale in binär codierter Form zugeführt werden, indem beispielsweise die möglichen vier logischen Pegel durch die Kombination von 2 Bits dargestellt werden.

Eines dieser Bits gibt dabei beispielsweise das Vorzeichen und das verbleibende Bit den logischen Pegel (3 bzw. 1) an. Den so dem Impulsformer gemäß den Figuren 6, 9 und 12 nacheinander zugeführten Bitkombinationen (2 Bits), die mit einer Geschwindigkeit von 80 kHz auftreten mögen, wird jeweils mit der Flanke eines 80-kHz-Taktes eine Abtastprobe entnommen. Die Abtastproben durchlaufen dann jeweils wie bei dem bereits beschriebenen Impulsformer (Figur 2) die Registerzellen der jeweiligen Schieberegister mit einer Geschwindigkeit von 640 kHz.

Der in Figur 6 dargestellte Impulsformer unterscheidet sich von dem in Figur 2 dargestellten Impulsformer lediglich darin, daß die den Umladenkondensatoren jeweils zugeordneten Schalter S3 und S4 für ihre Steuerung Taktsignale mit einer Taktfrequenz von 1,92 MHz zugeführt erhalten und daß mit den beiden Schieberegistern A und B eine weitere Verknüpfungsschaltung S verbunden ist. Diese Verknüpfungsschaltung steuert einen in Reihe zu dem Summierkondensator CI1 bzw. CI2 liegenden Schalter SH bzw. SH'. Über den jeweiligen Schalter werden, wie im folgenden noch erläutert werden wird, zu vorgegebenen Zeitpunkten die an dem zugehörigen Summierkondensator auftretenden Signale an einen nachgeschalteten Kondensator weitergeleitet. Der dem Summierkondensator CI1 nachgeschaltete Kondensator ist dabei mit CS1, der dem Summierkondensator CI2 nachgeschaltete Kondensator dagegen mit CS2 bezeichnet.

Die Bildung von +1- und -1- Sendeimpulsen erfolgt bei dem in Figur 6 dargestellten Impulsformer in der gleichen Weise wie bei dem bereits beschriebenen Impulsformer. D. h. durch eine entsprechende Ansteuerung der mit den Umladekondensatoren verbundenen Schalter S1 bis S4 durch die jeweils zugehörige Verknüpfungsschaltung erfolgt eine Ladungsumverteilung in denjenigen durch die Abtastproben festgelegten Perioden, in denen vom Verlauf des zu bildenden Ausgangssignals ein Spannungssprung erforderlich ist. Diese Ladungsumverteilung bewirkt dann, wie bereits erläutert, je nach der Richtung der Ladungsumverteilung einen positiven oder negativen Spannungssprung an dem Operationsverstärker GTV. Bei der Bildung von +3- und -3-Sendeimpulsen finden dagegen durch eine entsprechende Steuerung der Schalter S1 bis S4 von der zugehörigen Verknüpfungsschaltung her in den ausgewählten Perioden jeweils nacheinander drei Ladungsumverteilungen statt. In den in Frage kommenden Perioden treten also jeweils drei Spannungssprünge an dem Operationsverstärker GTV auf. Damit werden für +3- und -3-Sendeimpulse jeweils Ausgangssignale erzeugt, die bis auf die Anzahl der Stufen die gleiche Form wie den +1- und -1-Sendeimpulsen zugeordneten Ausgangssignale und eine gegenüber diesen um den Faktor 3 größere Amplitude aufweisen.

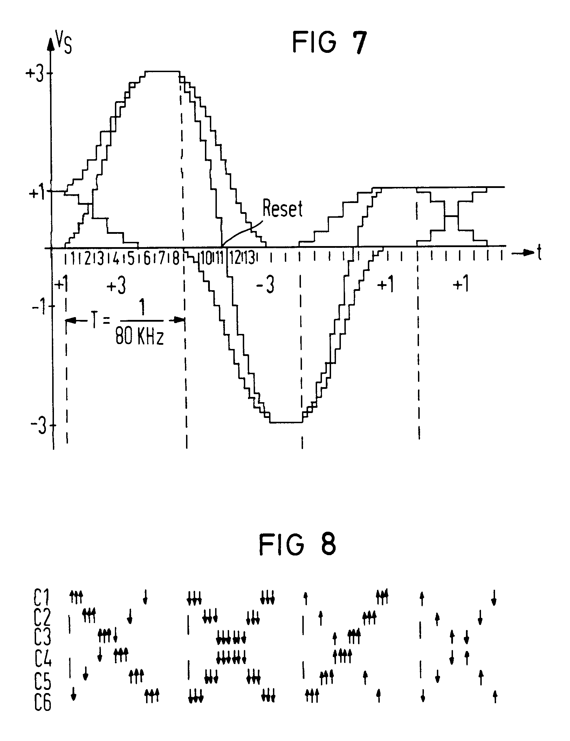

In Figur 7 ist als Beispiel eine Sendeimpulsfolge +1, +3, -3, -1, +1 dargestellt, wie sie am Ausgang des Operationsverstärkers GTV auftritt. Auch bei dieser Sendeimpulsfolge sind die einzelnen Sendeimpulse um den Faktor 13/8 breiter als die dem Impulsformer zugeführten Signale. Auf der Abszisse sind dabei die durch die Schieberegisteranordnung A, B festgelegten 640-kHz-Perioden aufgetragen, während auf der Ordinate die am Ausgang des Operationsverstärkers GTV auftretende Ausgangsspannung VS angegeben ist. In dem in Figur 8 dargestellten Pfeildiagramm ist die Reihenfolge angedeutet, in der die Umladekondensatoren (als Beispiel sind wiederum nur die Umladekondensatoren C1 bis C6 angegeben) bei der Sendeimpulsformung wirksam sind. Positive Spannungssprünge sind durch Pfeile nach oben und negative Spannungssprünge sind durch Pfeile nach unten symbolisch dargestellt. Drei nebeneinander gezeichnete Pfeile geben dabei an, daß bei der in Frage kommenden Periode nacheinander drei Spannungssprünge stattfinden. Die Größenverteilung der Umladekondensatoren ist wie bei dem Impulsformer gemäß Figur 2 durch die Anpassung der einzelnen Spannungsstufen an die $\sin^2$-Form festgelegt.

Aus den Figuren 7 und 8 geht hervor, daß auch bei der angenommenen Sendeimpulsfolge +1, +3, -3, +1, +1 eine Überlagerung der einzelnen Sendeimpulse erfolgt, beispielsweise bei der Sendeimpulsfolge +3, -3 in der neunten bis dreizehnten Periode. In der neunten Periode erfolgt z. B. wie bei einem einzelnen +3-Sendeimpuls eine dreifache Aufladung des Umladekondensators C6 von dem Summierkondensator CI1 her. Gleichzeitig erfolgt aber auch, wie aus dem Pfeildiagramm in Figur 8 hervorgeht, eine dreifache Aufladung des Umladekondensators C1 von dem Summierkondensator CI1 her. Entsprechende Überlagerungen treten auch bei den übrigen dargestellten Sendeimpulsübergängen auf. Da bei diesen Überlagerungen die gleichen Umladekondensatoren beteiligt sind wie bei den einzelnen Sendeimpulsen ist auch bei dem in Figur 6 dargestellten Impulsformer die Überlagerung linear und unabhängig von Kapazitätstoleranzen.

Tritt bei einer Sendeimpulsfolge eine Wechsel +1, -1 oder -1, +1 bzw. +3, -3 oder -3, +3 auf, so wird der Summierkondensator CI1 zur frühestmöglichen Periode, in der die Ausgangsspannung am Operationsverstärker GTV nominell null ist, kurzgeschlossen, d.h. entladen. In Figur 7 ist angedeutet, daß bei dem Übergang +3, -3 eine Entladung beispielsweise in der elften Periode erfolgt.

Der in Figur 6 dargestellte Schalter SK erhält für dieses Entladen von der Verknüpfungsschaltung R ein entsprechendes Rücksetzsignal zugeführt. Durch das Entladen des Summierkondensators CI1 bzw. CI2 werden wie bei dem Impulsformer gemäß Figur 2 aufgelaufene Summierungsfehler infolge einer endlichen Verstärkung und einer Offsetspannung des Operationsverstärkers GTV beseitigt. Die Offsetkompensation erfolgt dabei in der bereits oben angegebenen Weise.

Wie bereits vorstehend erläutert worden ist, weisen die an den Summierkondensatoren CI1 und CI2 auftretenden Ausgangssignale für +3- und -3-Sendeimpulse aufgrund einer dreifachen Ladungsumverteilung in den einzelnen Perioden gegenüber den Ausgangssignalen für +1- und -1-Sendeimpulse eine dreifache Anzahl von Stufen auf. Um die Anzahl dieser Stufen auf die Anzahl der Stufen für +1- und -1-Sendeimpulse zu reduzieren, sind die bereits genannten Schalter SH und SH' vorgesehen. Diese Schalter bilden jeweils in Verbindung mit den ihnen jeweils nachgeschalteten, in Figur 6 mit CS1 bzw. CS2 bezeichneten Kondensatoren eine Abtast- und Halteschalung. Die Schalter SH und SH' werden dabei von der Verknüpfungsschaltung S her derart gesteuert, daß sie lediglich im letzten Drittel einer jeden in Figur 7 dargestellten Periode geschlossen sind und somit lediglich die zu diesen festgelegten Zeitpunkten an den Summierkondensatoren anliegenden Ausgangsspannungen den Kondensatoren CS1 und CS2 zuführen. An den Kondensatoren CS1 und CS2 treten damit stets treppenförmige Ausgangssignale mit gleicher Stufenanzahl auf, d. h. die Form der Ausgangssignale ist für sämtliche Sendeimpulse gleich. Lediglich die Amplituden der Ausgangssignale für +3- bzw. -3-Sendeimpulse und +1- bzw. -1-Sendeimpulse unterscheiden sich um den Faktor 3.

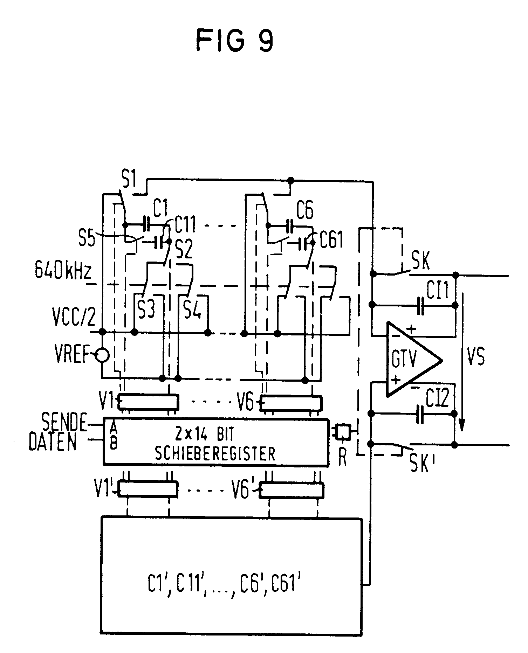

In Figur 9 ist eine zweite Weiterbildung des in Figur 2 dargestellten Impulsformers angegeben. Der Impulsformer gemäß Figur 6 unterscheidet sich dabei von dem in Figur 2 dargestellten Impulsformer lediglich darin, daß den Umladekondensatoren C1 bis C6 bzw. C1' bis C6' jeweils eine aus einem Schalter S5 und einem Zusatzkondensator bestehende Reihenschaltung parallelgeschaltet ist. Der dem Umladekondensator C1 paralellgeschaltete Zusatzkondensator ist dabei mit C11 bezeichnet. In entsprechender Weise tragen die übrigen Zusatzkondensatoren die Bezeichnung C21 bis C61 bzw. C11' bis C61'. Diese Zusatzkondensatoren weisen jeweils eine Kapazität auf, die doppelt so groß ist wie die Kapazität des zugehörigen Umladekondensators, also beispielsweise C11 = 2C1.

Die genannten Schalter S5 sind jeweils von der dem zugehörigen Umladekondensator zugehörigen Verknüpfungsschaltung her steuerbar. Beispielsweise ist also der dem Umladekondensator C1 zugehörige Schalter S5 von der Verknüpfungsschaltung V1 her steuerbar.

Die Bildung von +1- und -1-Sendeimpulsen erfolgt bei dem Impulsformer gemäß Figur 9 in der gleichen Weise wie bei den beiden vorher erläuterten Impulsformern. In die Ladungsumverteilung sind also wiederum die Umladekondensatoren C1 bis C6 bzw. C1' bis C6' einbezogen. Am Ausgang des Operationsverstärkers GTV treten dabei den Kapazitäten der Umladekondensatoren entsprechende Spannungssprünge auf, für den Umladekondensator C1 also beispielsweise Spannungssprünge dVS = C1/CI1.VREF bzw. dVS = -C1/CI1.VREF.

Bei der Bildung von +3- und -3-Sendeimpulsen sind dagegen durch eine Steuerung der den Umladekondensatoren zugeordneten Schalter S1 bis S5 in die Ladungsumverteilung sowohl die Umladekondensatoren als auch die diesen parallelschaltbaren Zusatzkondensatoren einbezogen. Durch die so gebildeten Kondensatorkombinationen werden dabei am Ausgang des Operationsverstärkers GTV Spannungssprünge hervorgerufen, die um den Faktor 3 höher liegen als bei der Bildung von +1- und -1-Sendeimpulsen. Bei Einbeziehung des Umladekondensators C1 und des Zusatzkondensators C11 in die Ladungsumverteilung entstehen also beispielsweise Spannungssprünge dVS = (C1+C11)/CI1.VREF bzw. dVS = - (C1+C11)-/CI1.VREF. Daraus resultiert, daß auch bei dem Impulsformer gemäß Figur 9 die Form und die Amplitude von +3- und -3-Sendeimpulsen unabhängig von den Kapazitätsverhältnissen sind. Die Amplituden sind dabei um den Faktor 3 größer als die Amplituden von +1- und -1-Sendeimpulsen. In die Amplitudenverhältnisse von Sendeimpulsen mit unterschiedlichen Pegeln, beispielsweise +1, +3, gehen zwar die Kapazitätstoleranzen der Umladekondensatoren und der ihnen parallelschaltbaren Zusatzkondensatoren ein. Diese Kapazitätstoleranzen können jedoch, insbesondere bei Ausführung des Impulsformers in integrierter Technik, in für die Praxis ausreichenden Grenzen gehalten werden.

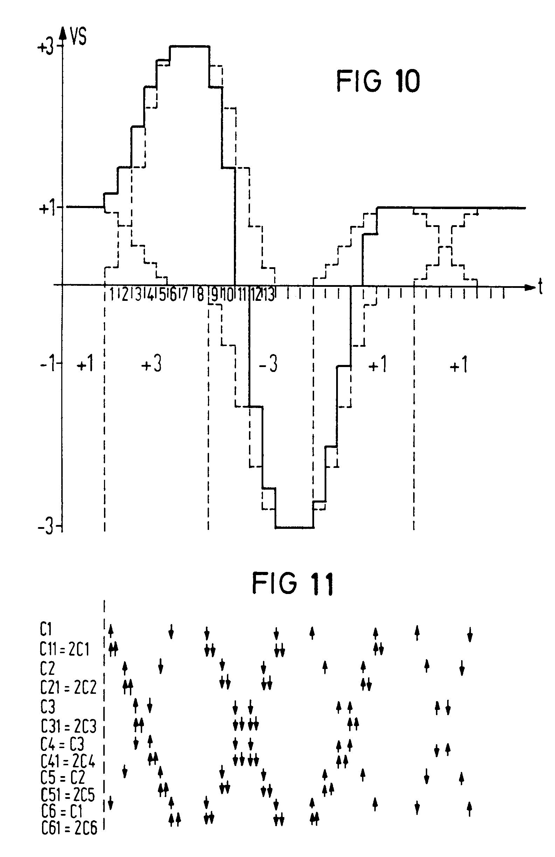

In Figur 9 ist wiederum lediglich als Beispiel eine Sendeimpulsfolge +1, +3, -3, +1, +1 dargestellt, wie sie am Ausgang des Operationsverstärkers GTV auftritt. Wie bereits im Zusammenhang mit Figur 7 erwähnt, sind die zu dieser Sendeimpulsfolge gehörenden Sendeimpulse um den Faktor 13/8 breiter als die dem Impulsformer zugeführten Signale. Auf der Abszisse sind wieder die durch die Schieberegisteranordnung A, B festgelegten 640-kHz-Perioden aufgetragen, während auf der Ordinate die am Ausgang des Operationsverstärkers GTV auftretende Ausgangsspannung VS angegeben ist. In dem in Figur 11 dargestellten Pfeildiagramm ist als Beispiel die Reihenfolge angedeutet, in der die Umladekondensatoren C1 bis C6 und die Zusatzkondensatoren C11 bis C61 bei der in Figur 10 dargestellten Sendeimpulsformung wirksam sind. Positive Spannungssprünge sind wiederum durch Pfeile nach oben und negative Spannungssprünge durch Pfeile nach unten symbolisch dargestellt. Zwei nebeneinander gezeichnete Pfeile deuten dabei an, daß der jeweilige Zusatzkondensator in der in Frage kommenden Periode zusätzlich zu dem zugehörigen Umladekondensator Ladung aufnimmt bzw. abgibt. Diese Ladung ist dabei doppelt so groß wie die von dem zugehörigen Umladekondensator aufgenommene bzw. abgegebene Ladung. In der mit 1 bezeichneten Periode gibt also beispielsweise die Kondensatorkombination C1 und C11 eine Ladung ab, die eine positive Spannungsänderung von dVS = (C1 + C11)-/CI1.VREF = 3C1/CI1.VREF am Ausgang des Operationsverstärkers GTV bewirkt.

Aus den Figuren 10 und 11 ergibt sich, daß auch bei dem Impulsformer gemäß Figur 9 eine Überlagerung der einzelnen Sendeimpulse erfolgt. Gemäß Figur 10 tritt eine solche Überlagerung beispielsweise bei der Sendeimpulsfolge +3, -3 in der neunten bis dreizehnten Periode auf. In der neunten Periode erfolgt z. B., wie aus Figur 11 hervorgeht, wie bei einem einzelnen +3-Sendeimpuls eine Aufladung des Umladekondensators C6 und des Zusatzkondensators C61 von dem Summierkondensator CI1 her. Gleichzeitig erfolgt aber auch eine Aufladung des Umladekondensators C1 und des Zusatzkondensators C11 von dem Summierkondensator CI1 her. Entsprechende Überlagerungen treten auch bei den übrigen in Figur 10 dargestellten Sendeimpulsübergängen auf. Da bei diesen Überlagerungen die gleichen Umladekondensatoren und Zusatzkondensatoren beteiligt sind, wie bei einzelnen Sendeimpulsen, ist auch hier die Überlagerung linear und unabhängig von Kapazitätstoleranzen.

Auch bei dem Impulsformer gemäß Figur 9 wird bei Auftreten eines Wechsels +1, -1 oder -1, +1 bzw. +3, -3 oder -3, +3 der Summierkondensator CI1 bzw. CI2 zur frühestmöglichen Periode, in der die Ausgangsspannung am Operationsverstärker GTV nominell null ist, kurzgeschlossen. Der Schalter SK erhält dafür wie bei dem Impulsformer gemäß Figur 6 von der Verknüpfungsschaltung R ein entsprechendes Rücksetzsignal zugeführt. Bei Auftreten dieses Rücksetzsignals wird gleichzeitig eine Offsetkompensation für den Operationsverstärker GTV in der oben bereits beschriebenen Weise durchgeführt.

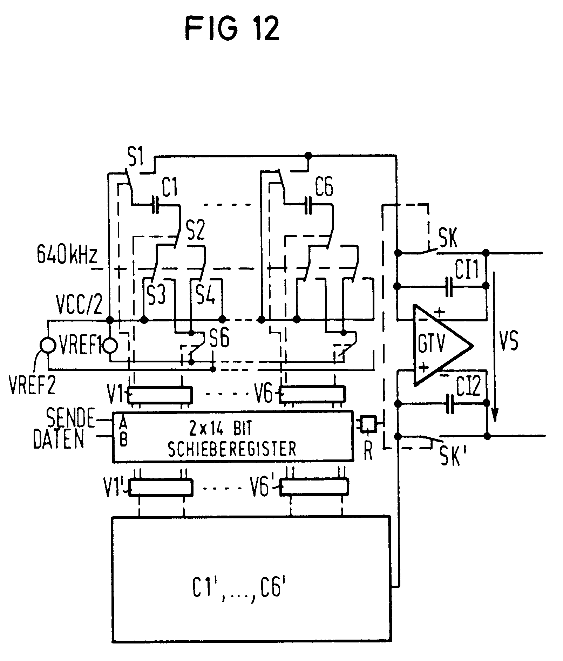

In Figur 12 ist eine dritte Weiterbildung des in Figur 2 dargestellten Impulsformers angegeben. Der Impulsformer gemäß Figur 12 unterscheidet sich dabei von dem in Figur 2 dargestellten Impulsformer lediglich darin, daß die den Umladekondensatoren zugeordneten Schalter S3 und S4 wahlweise an zwei unterschiedliche Bezugsspannungsquellen VREF1 und VREF2 anschaltbar sind. Die Bezugsspannungsquelle VREF2 gibt dabei gegenüber der Bezugsspannungsquelle VREF1 eine um den Faktor 3 höhere Bezugsspannung ab. Für die Auswahl der jeweils in Frage kommenden Bezugsspannungsquelle ist den Umladekondensatoren jeweils ein Schalter S6 zugeordnet, der, gesteuert durch die dem jeweiligen Umladekondensator zugehörige Verknüpfungsschaltung, wahlweise eine der beiden Bezugsspannungsquellen mit den genannten Schaltern S3 und S4 verbindet.

Die Bildung von +1, -1-Sendeimpulsen und +3, -3-Sendeimpulsen erfolgt durch Steuerung der den Umladekondensatoren C1 bis C6 bzw. C1' bis C6' zugeordneten Schaltern S1 bis S4 und S6 in der bereits für den Impulsformer gemäß Figur 2 angegebenen Weise. Ein Unterschied besteht lediglich darin, daß, gesteuert durch den jeweiligen Schalter S6, bei der Bildung von +1, -1-Sendeimpulsen in denjenigen Perioden, in denen vom Verlauf des zu bildenden Sendeimpulses ein Spannungssprung am Operationsverstärker GTV erforderlich ist, eine Ladungsumverteilung unter Einbeziehung der Bezugsspannungsquelle VREF1 erfolgt. In die Bildung von +3, -3-Sendeimpulsen ist dagegen in die Ladungsumverteilung die Bezugsspannungsquelle VREF2 einbezogen. Wie bereits oben erwähnt, gibt diese Bezugsspannungsquelle gegenüber der Bezugsspannungsquelle VREF1 eine um den Faktor 3 höhere Bezugsspannung ab.

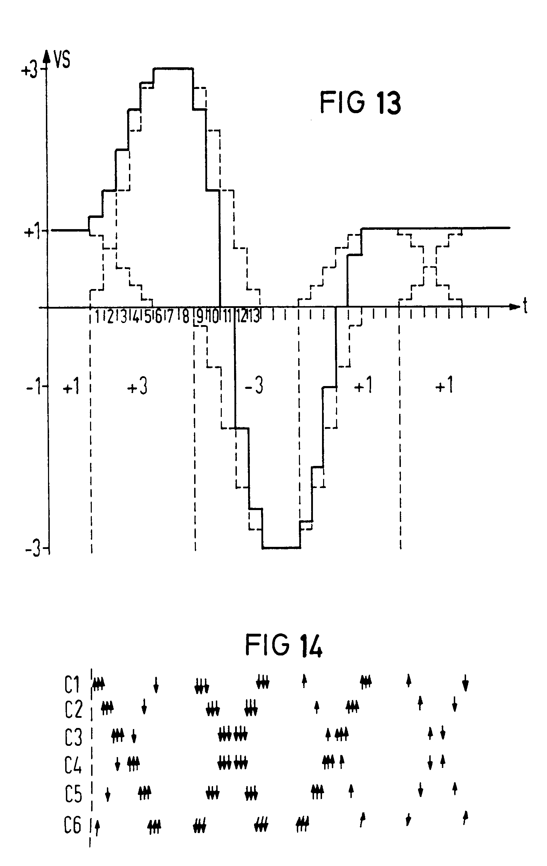

In Figur 13 ist als wiederum als Beispiel die einer Sendeimpulsfolge +1, +3, -3, +1, +1 entsprechende, am Ausgang des Operationsverstärkers GTV auftretende Sendeimpulsfolge dargestellt. Figur 13 ist dabei identisch mit der Figur 10. In dem in Figur 14 dargestellten Pfeildiagramm ist wiederum die Reihenfolge angedeutet, in der beispielsweise die Umnladekondensatoren C1 bis C6 bei der in Figur 13 dargestellten Sendeimpulsformung wirksam sind. Auch in dieser Figur sind positive Spannungssprünge durch Pfeile nach oben und negative Spannungssprünge durch Pfeile nach unten symbolisch dargestellt. Die Anzahl der in den einzelnen Perioden für die Umladekondensatoren gezeichneten Pfeile gibt dabei die Höhe der Spannungssprünge an, die durch die Umladekondensatoren in Verbindung mit den beiden Bezugsspannungsquellen VREF1 und VREF2 gerade verursacht werden.

Da bei dem Impulsformer gemäß Figur 12 für die Bildung von +1, -1-Sendeimpulsen und +3, -3-Sendeimpulsen stets die gleichen Umladekondensatoren beteiligt sind, ist die Form für die genannten Sendeimpulse unabhängig von den Kapazitätsverhältnissen gleich. In die Amplitudenverhältnisse der Sendeimpulse für unterschiedliche Pegel, beispielsweise +1, +3, gehen zwar die Toleranzen der Bezugsspannungsquellen ein. Diese Toleranzen können jedoch in für die Praxis ausreichenden Grenzen gehalten werden.

Die Ausführungen im Zusammenhang mit den Impulsformern gemäß der Figuren 6 und 9 bezüglich der Überlagerung von einzelnen Sendeimpulsen und bezüglich der Festlegung des Zeitpunktes für das Kurzschließen des Summierkondensators CI1 bzw. CI2 gelten auch für den Impulsformer gemäß Figur 12.

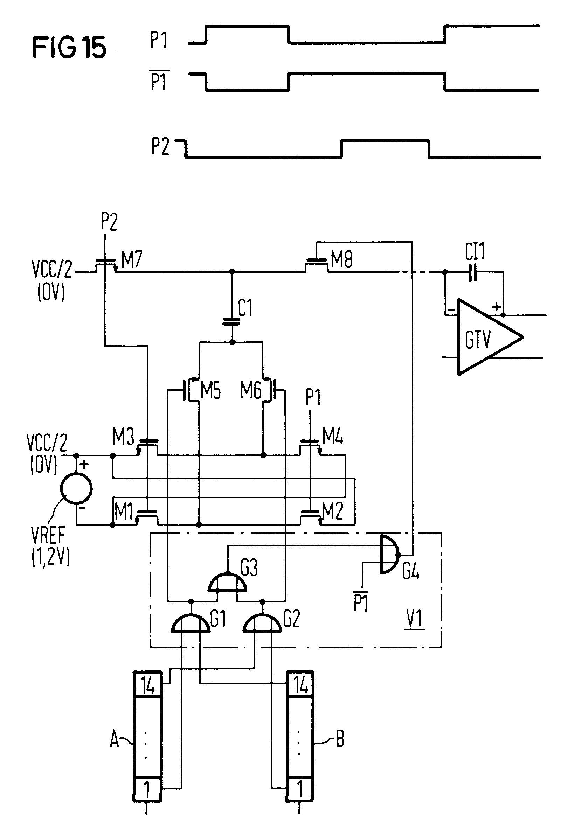

Im folgenden wird nun noch am Beispiel des in Figur 2 dargestellten Impulsformers gezeigt, wie die in Figur 2 lediglich schematisch dargestellten, den Umladekondensatoren jeweils zugeordneten Schalter S1 bis S4 beispielsweise durch MOS-FET-Transistoranordnungen realisiert werden können und wie diese durch die ihnen jeweils zugeordnete Verknüpfungsschaltung angesteuert werden können. Figur 15 zeigt dazu die dem Umladekondensator C1 (Figur 2) zugeordnete Schalteranordnung S1 bis S4 und die mit dieser verbundene Verknüpfungsschaltung V1.

Die in Figur 15 dargestellte Schalteranordnung weist zwei in Reihe geschaltete Transistoren M7 und M8 auf, die mit ihren Source-Anschlüssen miteinander verbunden sind. Diese beiden Transistoren bilden den Umschalter S1. Der Drain-Anschluß des Transistors M7 ist an VCC/2 (die beispielsweise 0 V betragen möge) angeschlossen. Der Drain-Anschluß des Transistors M8 steht mit dem an den "-"-Eingang des Operationsverstärkers GTV angeschlossen Anschluß des Summierkondensators CI1 in Verbindung. An den Verbindungspunkt der beiden Transistoren ist der Umladekondensator C1 mit einem seiner Anschlüsse angeschlossen. Der andere Anschluß dieses Umladekondensators steht mit den Source-Anschlüssen zweier Transistoren M5 und M6 in Verbindung. Diese Transistoren bilden den Umschalter S2. Mit dem Drain-Anschluß des Transistors M5 ist der Verbindungspunkt einer aus zwei Transistoren M1 und M2 bestehenden, den Umschalter S4 bildenden Reihenschaltung verbunden. Den Verbindungspunkt bilden dabei die Drain-Anschlüsse dieser Transistoren. Der Source-Anschluß des Transistors M1 ist an den "-"-Anschluß der Bezugsspannungsquelle VREF angeschlossen, deren "+"-Anschluß mit VCC/2 verbunden ist. Die von dieser abgegebene Bezugsspannung möge beispielsweise 1,2 V betragen. Der Transistor M2 ist dagegen mit seinem Source-Anschluß mit VCC/2, also beispielsweise 0 V, verbunden.

Der genannte Transistor M6 ist an einem Verbindungspunkt einer aus zwei Transistoren M3 und M4 bestehenden Reihenschaltung angeschlossen. Den Verbindungspunkt bilden dabei die Drain-Anschlüsse dieser Transistoren. Diese Transistoren stellen den Umschalter S3 dar. Der Source-Anschluß des Transistors M3 steht mit VCC/2 (0 V), der Source-Anschluß des Transistors M4 dagegen mit dem bereits genannten "-"-Anschluß der Bezugsspannungsquelle in Verbindung.

In Figur 15 sind weiterhin die beiden Schieberegister A und B mit ihren jeweils 14 Registerzellen dargestellt. Mit der ersten Registerzelle des Schieberegister A und der vierzehnten Registerzelle des Schieberegisters B steht jeweils ein Eingang eines OR-Gliedes G1 in Verbindung. Der Ausgang dieses OR-Gliedes ist einerseits mit dem Gate-Anschluß des Transistors M5 und andererseits mit einem ersten Eingang eines NOR-Gliedes G3 verbunden. Die erste Registerzelle des Schieberegisters B und die vierzehnte Registerzelle des Schieberegisters A stehen mit den beiden Eingängen eines OR-Gliedes G2 in Verbindung. Der Ausgang dieses OR-Gliedes ist einerseits mit dem Gate-Anschluß des Transistors M6 und andererseits mit dem zweiten Eingang des bereits genannten NOR-Gliedes G3 verbunden. Mit seinem Ausgang ist dieses NOR-Glied an einem ersten Eingang eines weiteren NOR-Glieds G4 angeschlossen. Der zweite Eingang dieses NOR-Gliedes ist mit der Taktphase $\overline{P1}$ des in der oberen Hälfte des in Figur 15 dargestellten 960-kHz-Taktsignals beaufschlagt. Der Ausgang des NOR-Gliedes G4 ist mit dem Gate-Anschluß des Transistors M8 verbunden.

Die genannten Transistoren M1, M3 und M7 sind jeweils an ihrem Gate-Anschluß mit der Taktphase P2 beaufschlagt. Die Transistoren M2 und M4 erhalten dagegen jeweils an ihrem Gate-Anschluß Taktsignale mit der Phase P1 zugeführt, die, wie aus den in Figur 15 angegebenen Taktsignalen hervorgeht, nicht überlappend zu der Phase P2 ist.

Im folgenden wird nun die Wirkungsweise der gerade beschriebenen Schaltungsanordnung erläutert. Mit dem OR-Glied G1 werden die Zustände ausgewählt, bei denen der Umladekondensator C1 einen positiven Spannungssprung am Ausgang des Operationsverstärkers GTV hervorrufen soll. Dies ist nach der in Figur 2 angegebenen Wertetabelle und der in Figur 3b dargestellten Sendeimpulsfolge der Fall in der ersten Periode eines +1-Sendeimpulses und in der vierzehnten Periode eines -1-Sendeimpulses. Diese Perioden sind durch die oben angegebene Verbindung des OR-Gliedes G1 mit den Schieberegistern A und B festgelegt.

Mit dem OR-Glied G2 werden diejenigen Zustände ausgewählt, bei denen der Umladekondensator C1 einen negativen Spannungssprung am Ausgang des Operationsverstärkers GTV hervorrufen soll. Diese Zustände treten, wie wiederum aus Figur 3b und der Wertetabelle in Figur 2 hervorgeht, in der ersten Periode eines -1-Sendeimpulses und in der vierzehnten Periode eines +1-Sendeimpulses auf.

Für die Erzeugung eines positiven Spannungssprunges am Ausgang des Operationsverstärkers GTV (Logisch-1-Pegel liegt in der ersten Registerzelle des Schieberegisters A oder in der vierzehnten Registerzelle des Schieberegisters B an) wird der Transistor M5 über das OR-Glied G1 leitfähig gesteuert. Mit der Taktphase P2 (positiver Impuls) wird dann zunächst der Umladekondensator C1 über die Transistoren M1, M5 und M7 auf die Bezugsspannung VREF aufgeladen. Mit der Taktphase P1 bzw. $\overline{P1}$ (positiver Impuls) werden die Transistoren M2 und M8 leitfähig gesteuert. Damit liegt der Umladekondensator C1 mit seinen beiden Anschlüssen an 0 V (VCC/2), und die Ladung fließt zu dem Summierkondensator CI1 ab. Damit entsteht am Ausgang des Operationsverstärkers GTV ein positiver Spannungssprung.

Für die Erzeugung eines negativen Spannungssprunges (Logisch-1-Pegel liegt in der ersten Registerzelle des Schieberegisters B oder in der vierzehnten Registerzelle des Schieberegisters A an) wird der Transistor M6 leitfähig gesteuert. Mit der nächsten Taktphase P2 wird der Umladekondensator C1 über die Transistoren M3, M6 und M7 entladen. Mit der Taktphase P1 bzw. $\overline{P1}$ werden die Transistoren M4 und M8 leitfähig gesteuert. Damit liegt der Umladekondensator C1 zwischen dem Summierkondensator CI1 und der Bezugsspannung VREF und übernimmt somit Ladung aus dem Summierkondensator CI1. Dies bewirkt einen negativen Spannungssprung am Ausgang des Operationsverstärkers GTV.

Bezüglich der in Figur 15 dargestellten NOR-Glieder G3 und G4 sei noch darauf hingewiesen, daß diese den Transistor M8 lediglich dann leitfähig steuern, wenn der Umladekondensator C1 tatsächlich an einer Ladungsumverteilung beteiligt ist.

Vorstehend wurde lediglich anhand der Figur 15 die Erzeugung von positiven und negativen Spannungssprüngen am Ausgang des Operationsverstärkers GTV am Beispiel des Umladekondensators C1 erläutert. Entsprechende Vorgänge laufen aber auch für die übrigen Umladekondensatoren C2 bis C6 bzw. C1' bis C6' ab, wenn diese durch die ihnen jeweils zugeordnete, der Verknüpfungsschaltung V1 entsprechende Verknüpfungsschaltung angesteuert werden. Die Zeitpunkte, in denen die einzelnen Umladekondensatoren zu aktivieren sind, werden durch eine entsprechende Verbindung der den Verknüpfungsschaltungen jeweils zugehörigen OR-Gliedern G1 und G2 mit ausgewählten Registerzellen der Schieberegister A und B festgelegt. Die Festlegung ergibt sich aus Figur 3b in Verbindung mit der in der Figur 2 angegebenen Wertetabelle.

Für die in den Figuren 6, 9 und 12 dargestellten Impulsformer sind der in Figur 15 dargestellten Verknüpfungsschaltung V1 entsprechende, an die Bildung von vierpegeligen Sendeimpulsen angepaßte Verknüpungsschaltungen vorgesehen. Auch bei diesen Verknüpfungsschaltungen werden ausgewählte Registerzellen der Schieberegister A und B mit in den Verknüpfungsschaltungen jeweils enthaltenen, dem Fachmann geläufigen logischen Verknüpfungsgliedern derart verbunden, daß einerseits die Zeitpunkte für die Aktivierung der einzelnen Umladekondensatoren festgelegt ist und andererseits die zu diesen Zeitpunkten für die Bildung von +3, -3-Sendeimpulsen erforderlichen, anhand der Figuren 6, 9 und 12 beschriebenen Einrichtungen aktiviert sind. Dies sind bei den Impulsformern gemäß Figur 9 und 12 die Schalter S5 und S6. Bei dem Impulsformer gemäß Figur 6 ist dagegen für die Bildung von +3, -3-Sendeimpulsen jeder ausgewählte Umladekondensator durch eine entsprechende Steuerung der jeweils zugehörigen Schalter S1 bis S4 dreimal nacheinander in eine Ladungsumverteilung einzubeziehen.

Auch die in den Figuren 2, 6, 9 und 12 angegebene Verknüpfungsschaltung R und die in Figur 6 zusätzlich angegebene Verknüpfungsschaltung S enthalten jeweils ebenfalls lediglich dem Fachmann geläufige logische Verknüpfungsglieder, um anhand der die Schieberegister A und B durchlaufenden Abtastproben die Zeitpunkte für das Kurzschließen der Summierkondensatoren CI1 und CI2 bzw. das Schließen der Schalter SH und SH' zu steuern.

Vorstehend wurden Impulsformer für die Bildung von dreipegeligen und vierpegeligen Sendeimpulsen mit symmetrischen treppenförmigen Flanken erläutert. Mit den beschriebenen Impulsformern können jedoch auch durch entsprechende Wahl der Anzahl der Umladekondensatoren und der Kapazität der Umladekondensatoren Sendeimpulse mit beliebigen treppenförmigen Flanken, also beispielswiese mit unsymmetrischen Flanken, gebildet werden. Darüber hinaus können die beschriebenen Impulsformer durch eine entsprechende Anpassung bzw. Erweiterung auch für die Bildung von beliebigen mehrpegeligen Sendeimpulsen ausgelegt werden.

Abschließend sei noch darauf hingewiesen, daß zwar bei den zuvor beschriebenen Impulsformern jeweils eine Schieberegisteranordnung A, B Steuersignale für die mit dieser verbundenen Verknüpfungsschaltungen bereitstellt. Anstelle dieser Schieberegisteranordnung kann aber auch eine allgemein als Steuersignalgeber zu bezeichnende Einrichtung mit einer der Anzahl der Registerzellen der Schieberegisteranordnung A, B entsprechenden Anzahl von Ausgängen benutzt sein, welche auf das Auftreten von dem jeweiligen Impulsgeber zugeführten Signalen an ihren Ausgängen nacheinander Steuersignale in äquidistanten zeitlichen Abständen abgibt. Diese Steuersignale dienen wie die an den Registerzellen der beschriebenen Schieberegisteranordnung auftretenden Signale für die Ansteuerung der in den beschriebenen Impulsformern vorhandenen Verknüpfungsschaltungen. Als Beispiel für einen derartigen Steuersignalgeber sei hier beispielsweise ein Taktgenerator genannt, der mit dem jeweiligen Impulsgeber zugeführten Signalen beaufschlagt ist.

## Patentansprüche

1. Impulsformer für die Umformung von mehrpegeligen, zu einer Eingangssignalfolge gehörenden Eingangs-Digitalsignalen mit sprunghaften Pegelübergängen in treppenförmige Pegelübergänge aufweisende Ausgangs-Digitalsignale, welche durch eine lineare Überlagerung eine der Eingangssignalfolge entsprechende Ausgangssignalfolge bilden, mit einem eine Vielzahl von Ausgängen aufweisenden Steuersignalgeber (A,B), welcher auf das Auftreten eines Eingangs-Digitalsignals hin an seinen Ausgängen nacheinander Steuersignale in äquidistanten zeitlichen Abständen abgibt, die in ihrer Gesamtheit die Dauer eines Ausgangs-Digitalsignals festlegen, und mit einem zumindest an einem Teil der Ausgänge des Steuersignalgebers angeschlossenen Summiernetzwerk (C1 bis C6, CI1 bzw. C1' bis C6', CI2), welches zu durch das Auftreten von Steuersignalen an den mit ihm verbundenen Ausgängen des Steuersignalgebers festgelegten Zeitintervallen jeweils ein dem jeweiligen Ausgang zugeordnetes, einer festgelegten Stufe des zu bildenden Ausgangs-Digitalsignals entsprechendes Teilsignal bereitstellt und die zeitlich nacheinander auftretenden Teilsignale zu dem genannten treppenförmigen Ausgangs-Digitalsignal aufsummiert, **dadurch gekennzeichnet,** daß das Summiernetzwerk aus einer der Stufenanzahl eines Ausgangs-Digitalsignals entsprechenden Anzahl von Teilladungen bildenden Umladekondensatoren (C1 bis C6 bzw. C1' bis C6') und einem die Teilladungen aufsummierenden Summierkondensator (CI1 bis CI2) gebildet ist,
daß die Umladekondensatoren für die Bildung einer Teilladung jeweils über eine steuerbare Schalteranordnung (S1 bis S4) mit einem ihrer Anschlüsse an den Summierkondensator (CI1 bzw. CI2) oder an einen ersten Anschluß der Bezugsspannungsquelle (VREF1) und mit dem verbleibenden Anschluß an den ersten oder einen zweiten Anschluß der Bezugsspannungsquelle anschaltbar sind, daß die Schalteranordnungen für ihre Steuerung jeweils über eine Verknüpfungsschaltung (V1 bis V6 bzw. V1' bis V6') mit festgelegten Ausgängen des Steuersignalgebers verbunden sind und daß die jeweilige Verknüpfungsschaltung bei Auftreten eines Steuersignals an den mit ihr verbundenen Ausgängen des Steuersignalgebers die zugeordnete Schalteranordnung derart steuert, daß der mit dieser verbundene Umladekondensator entsprechend der bei Auftreten des jeweiligen Steuersignals zu bildenden Stufe Teilladung an den Summierkondensator abgibt bzw. von diesem aufnimmt.

2. Impulsformer nach Anspruch 1, **dadurch gekennzeichnet,**
daß der Steuersignalgeber aus einer Schieberegisteranordnung (A,B) mit einer der Vielzahl der Steuersignale entsprechenden Vielzahl von Registerzellen gebildet ist,
daß die Schieberegisteranordnung die Information bezüglich der zu bildenden mehrpegeligen Ausgangs-Digitalsignale binär codiert zugeführt erhält und diesen jeweils eine Abtastprobe entnimmt,
daß die jeweilige Abtastprobe nacheinander die Registerzellen mit einer den äquidistanten zeitlichen Abständen der Steuersignale entsprechenden Geschwindigkeit durchläuft
und daß jedes Auftreten einer Abtastprobe in den Registerzellen ein Steuersignal darstellt.

3. Impulsformer für die Bildungng von vierpegeligen Ausgangs-Digitalsignalen, welche zwei erste, zu einem Referenzwert symmetrisch liegende Werte und zwei zweite, ebenfalls symmetrisch zu dem Referenzwert liegende und von den ersten Werten um einen festgelegten ganzzahligen Faktor sich unterscheidende Werte annehmen können, nach Anspruch 1 oder 2, **dadurch gekennzeichnet,**
daß bei Auftreten eines einem Ausgangs-Digitalsignal mit einem ersten Wert entsprechenden binär codierten Signal die Umladekondensatoren (C1 bis C6 bzw. C1' bis C6') für die Bildung einer Teilladung jeweils in den für sie festgelegten Zeitintervallen lediglich einmal Ladung an den Summierkondensator (CI1 bzw. CI2) abgeben bzw. von diesem aufnehmen, während bei Auftreten eines einem Ausgangs-Digitalsignal mit einem zweiten Wert entsprechenden binär codierten Signal die Umladekondensatoren entsprechend dem festgelegten Faktor mehrfach Ladung an den Summierkondensator abgeben bzw. von diesem aufnehmen.

4. Impulsformer nach Anspruch 3, **dadurch gekennzeichnet,** daß mit dem Summierkondensator (CI1 bzw. CI2) ein Schalter (SH bzw. SH') verbunden ist, welcher von einer gesonderten, mit festgelegten Ausgängen des Steuersignalgebers (A, B) verbundenen Verknüpfungsschaltung (S) derart steuerbar ist, daß von dem Summierkondensator lediglich am Ende eines jeden Zeitintervalls das von diesem bis dahin gebildete Ausgangssignal abgebbar ist.

**5.** Impulsformer für die Bildung von vierpegeligen Ausgangs-Digitalsignalen, welche zwei erste, zu einem Referenzwert symmetrisch liegende Werte und zwei zweite, ebenfalls symmetrisch zu dem Referenzwert liegende und von den ersten Werten um einen festgelegten ganzzahligen Faktor sich unterscheidende Werte annehmen können, nach Anspruch 1 oder 2,
**dadurch gekennzeichnet,** daß bei Auftreten eines einem Ausgangs-Digitalsignal mit einem zweiten Wert entsprechenden binär codierten Signal den Umladekondensatoren (C1 bis C6 bzw. C1' bis C6') jeweils eine Zusatzkondensator (C11, ...., C61 bzw. C11',...., C61') parallelgeschaltet ist, dessen Kapazität derart festgelegt ist, daß die jeweilige, aus Umladekondensator und Zusatzkondensator bestehende Kondensatorkombination eine dem festgelegten Faktor entsprechend höhere Ladung an den Summierkondensator (CI1 bzw. CI2) abgibt bzw. von diesem aufnimmt.

**6.** Impulsformer nach Anspruch 5, **dadurch gekennzeichnet,** daß mit jedem Zusatzkondensator (C11,...., C61 bzw. C11',...., C61') ein Schalter (S5 bzw. S5') in Reihe geschaltet ist, welcher von der dem jeweiligen Umladekondensator zugeordneten Verknüpfungsschaltung (V1,...., V6 bzw. V1',...., V6') her derart steuerbar ist, daß der jeweilige Zusatzkondensator lediglich bei Auftreten von Ausgangs-Digitalsignalen mit einem zweiten Wert entsprechenden binär codierten Signalen dem zugehörigen Umladekondensator parallelgeschaltet ist.

**7.** Impulsformer für die Bildung von vierpegeligen Ausgangs-Digitalsignalen, welche zwei erste, zu einem Referenzwert symmetrisch liegende Werte und zwei zweite, ebenfalls symmetrisch zu dem Referenzwert liegende und von den ersten Werten um einen festgelegten ganzzahligen Faktor sich unterscheidende Werte annehmen können, nach Anspruch 1 oder 2, **dadurch gekennzeichnet,** daß die Umladekondensatoren (C1 bis C6 bzw. C1' bis C6') bei Auftreten eines einem Ausgangs-Digitalsignal mit einem ersten Wert entsprechenden binär codierten Signal an die genannte Bezugsspannungsquelle (VREF1), bei Auftreten eines einem Ausgangs-Digitalsignal mit einem zweiten Wert entsprechenden binär codierten Signal dagegen jeweils an eine zweite Bezugsspannungsquelle (VREF2) anschaltbar sind, deren Ausgangsspannung derart festgelegt ist, daß der jeweilige Umladekondensator eine dem festgelegten Faktor entsprechend höhere Ladung an den Summierkondensator (CI1 bzw. CI2) abgibt bzw. von diesem aufnimmt.

**8.** Impulsformer nach Anspruch 7, **dadurch gekennzeichnet,** daß für die Auswahl der für die Umladekondensatoren (C1 bis C6 bzw. C1' bis C6') jeweils in Frage kommenden Bezugsspannungsquelle für jeden der Umladekondensatoren eine weitere Schalteranordnung (S6) vorgesehen ist, welche von der dem jeweiligen Umladekondensator zugeordneten Verknüpfungsschaltung (V1.....V6 bzw. V1',...., V6') her steuerbar ist.

**9.** Impulsformer nach einem der Ansprüche 1 bis 8, **dadurch gekennzeichnet,** daß parallel zu dem Summierkondensator (CI1 bzw. CI2) ein weiterer Schalter (SK bzw. SK') vorgesehen ist, welcher von einer weiteren, mit festgelegten Ausgängen des Steuersignalgebers (A, B) verbundenen Verknüpfungsschaltung (R) derart steuerbar ist, daß er den Summierkondensator (CI1 bzw. CI2) in festgelegten Zeitintervallen kurzschließt.

**10.** Impulsformer nach einem der Ansprüche 1 bis 9, **dadurch gekennzeichnet,** daß das Summiernetzwerk zweifach vorhanden ist
daß die beiden Summierkondensatoren (CI1 und CI2) jeweils mit einem der Eingänge und einem diesem jeweils zugeordneten Ausgang eines Gegentaktoperationsverstärkers (GTV) verbunden sind und daß das Aufnehmen und das Abgeben von Teilladungen durch die Umladekondensatoren in den beiden Summiernetzwerken vertauscht sind.

**11.** Impulsformer nach Anspruch 10, **dadurch gekennzeichnet,** daß für den Gegentaktoperationsverstärker (GTV) in Zeitintervallen, in denen die Summierkondensatoren (CI1 und CI2) kurzgeschlossen sind, eine Offsetkompensation durchgeführt wird.

## Claims

**1.** Pulse shaper for reshaping multi-level input digital signals associated with an input signal sequence and with abrupt level transitions into output digital signals having staircase-type level transitions, which form an output signal sequence corresponding to the input signal sequence by means of a linear superposition, with a control signal generator (A, B) having a plurality of outputs which, upon the occurrence of an input digital signal, successively outputs control signals at equidistant time intervals at its outputs, the totality of which control signals defines the duration of an output digital signal, and with a summing network (C1 to C6, CI1 or C1' to C6', CI2) which is connected to at least some of the outputs of the control signal generator and which provides, at time intervals defined by the occurrence of control signals at the outputs of the control signal generator connected thereto, in each case one component signal associated with the respective output and corresponding to a defined step of the output digital signal to be formed, and which adds the component signals occurring in temporal succession to form the aforesaid staircase-type output digital signal, characterised in that the summing network is formed from a number, corresponding to the number of steps of an output digital signal, of recharging capacitors (C1 to C6 or C1' to C6') that form partial charges and a summing capacitor (CI1 to CI2) that adds the partial charges, in that, for the formation of a partial charge, the recharging capacitors can be connected with one of their terminals in each case via a controllable switch arrangement (S1 to S4) to the summing capacitor (CI1 or CI2), or to a first terminal of the reference voltage source (VREF1), and with the remaining terminal to the first or a second terminal of the reference voltage source, in that, for their control, the switch arrangements are connected in each case via a logic circuit (V1 to V6 or V1' to V6') to defined outputs of the control signal generator, and in that, upon the occurrence of a control signal at the outputs of the control signal generator connected thereto, the respective logic circuit controls the associated switch arrangement in such a way that the recharging capacitor connected thereto outputs a partial charge to the summing capacitor, or receives a partial charge therefrom respectively, in accordance with the step to be formed upon the occurrence of the respective control signal.

**2.** Pulse shaper according to Claim 1, characterised in that the control signal generator is formed from a shift register arrangement (A, B) with a plurality of register cells corresponding to the plurality of control signals, in that the shift register arrangement receives the information relating to the multi-level output digital signals to be formed in binary code and extracts a sample therefrom in each case, in that the respective sample passes successively through the register cells at a rate corresponding to the equidistant time intervals of the control signals, and in that each occurrence of a sample in the register cells represents a control signal.

**3.** Pulse shaper for the formation of four-level output digital signals which can assume two first values symmetrical to a reference value and two second values which are likewise symmetrical to the reference value and which differ from the first values by a defined integer factor according to Claim 1 or 2, characterised in that, upon the occurrence of a binary-coded signal corresponding to an output digital signal with a first value, the recharging capacitors (C1 to C6 or C1' to C6') only once output a charge to the summing capacitor (CI1 or CI2), or receive a charge therefrom respectively, in the time intervals defined for them in each case for the formation of a partial charge, whereas upon the occurrence of a binary-coded signal corresponding to an output digital signal with a second value, the recharging capacitors output a charge several times to the summing capacitor, or receive a charge several times therefrom respectively, in accordance with the defined factor.

**4.** Pulse shaper according to Claim 3, characterised in that connected to the summing capacitor (CI1 or CI2) is a switch (SH or SH') which can be controlled by a separate logic circuit (S), connected to defined outputs of the control signal generator (A, B), in such a way that only at the end of each time interval can the summing capacitor output the output signal that has been formed by it by that time.

**5.** Pulse shaper for the formation of four-level output digital signals which can assume two first values symmetrical to a reference value and two second values which are likewise symmetrical to the reference value and which differ from the first values by a defined integer factor according to Claim 1 or 2, characterised in that, upon the occurrence of a binary-coded signal corresponding to an output digital signal with a second value, an auxiliary capacitor (C11, ...., C61, or C11', ...., C61') is connected in parallel with the recharging capacitors (C1 to C6 or C1' to C6') in each case, the capacitance of which auxiliary capacitor is defined in such a way that the respective capacitor combination, comprising recharging capacitor and auxiliary capacitor, outputs a higher charge in accordance with the defined factor to the summing capacitor (CI1 or CI2), or receives a higher charge therefrom respectively.

**6.** Pulse shaper according to Claim 5, characterised in that connected in series with each auxiliary capacitor (C11, ...., C61 or C11', ...., C61') is a switch (S5 or S5') which can be controlled by the logic circuit (V1, ...., V6 or V1', ...., V6'), associated with the respective recharging capacitor, in such a way that the respective auxiliary capacitor is connected in parallel with the associated recharging capacitor only upon the occurrence of output digital signals with binary-coded signals corresponding to a second value.

**7.** Pulse shaper for the formation of four-level output digital signals which can assume two first values symmetrical to a reference value and two second values which are likewise symmetrical to the reference value and which differ from the first values by a defined integer factor according to Claim 1 or 2, characterised in that, upon the occurrence of a binary-coded signal corresponding to an output digital signal with a first value, the recharging capacitors (C1 to C6 or C1' to C6') can be connected to the aforesaid reference voltage source (VREF1), whereas upon the occurrence of a binary-coded signal corresponding to an output digital signal with a second value they can be connected in each case to a second reference voltage source (VREF2), the output voltage of which is defined in such a way that the respective recharging capacitor outputs a higher charge in accordance with the defined factor to the summing capacitor (CI1 or CI2), or receives a higher charge therefrom respectively.

**8.** Pulse shaper according to Claim 7, characterised in that a further switch arrangement (S6) is provided for each of the recharging capacitors for the selection of the reference voltage source in question for the recharging capacitors (C1 to C6 or C1' to C6') in each case, which switch arrangement can be controlled by the logic circuit (V1, ...., V6 or V1', ...., V6') associated with the respective recharging capacitor.

**9.** Pulse shaper according to one of Claims 1 to 8, characterised in that a further switch (SK or SK') is provided, which is connected in parallel with the summing capacitor (CI1 or CI2) and which can be controlled by a further logic circuit (R) connected to defined outputs of the control signal generator (A, B) in such a way that it short-circuits the summing capacitor (CI1 or CI2) at defined time intervals.

**10.** Pulse shaper according to one of Claims 1 to 9, characterised in that the summing network is present in duplicate, in that the two summing capacitors (CI1 and CI2) are connected in each case to one of the inputs and one output of a push-pull operational amplifier (GTV) associated therewith in each case, and in that the receiving and the outputting of partial charges by the recharging capacitors are exchanged in the two summing networks.

**11.** Pulse shaper according to Claim 10, characterised in that an offset compensation is performed for the push-pull operational amplifier (GTV) at time intervals during which the summing capacitors (CI1 and CI2) are short-circuited.

**Revendications**

**1.** Dispositif de mise en forme d'impulsions pour la transformation de signaux numériques d'entrée à plusieurs niveaux, qui sont associés à une suite de signaux d'entrée et présentent des transitions brusques entre niveaux, en des signaux numériques de sortie qui possèdent des transitions entre niveaux en forme d'escalier et forment, grâce à une superposition linéaire, une suite de signaux de sortie qui correspondent à la suite de signaux d'entrée, et comportant un générateur de signaux de commande (A,B), qui possède une multiplicité de sorties et qui, lors de l'apparition d'un signal numérique d'entrée, délivre successivement, sur ses sorties, des signaux de commande séparés par des intervalles de temps identiques et qui déterminent, dans leur globalité, la durée d'un signal numérique de sortie, et comportant un réseau additionneur (C1 à C6, CI1 ou C1' à C6', CI2), qui est raccordé au moins à une partie des sorties du générateur de signaux de commande et qui, à des intervalles de temps déterminés par l'apparition de signaux de commande sur les sorties, qui sont raccordées à ce réseau, du générateur de signaux de commande, prépare respectivement un signal partiel, qui est associé à la sortie respective et correspond à un échelon fixe du signal numérique de sortie devant être formé, et ajoute les signaux partiels, qui apparaissent successivement dans le temps, audit signal numérique de sortie en forme d'escalier, caractérisé par le fait que le réseau additionneur est formé par un nombre, qui correspond au nombre d'échelons d'un signal numérique de sortie, de condensateurs d'inversion de charge (C1 à C6 ou C1' à C6'), qui forment des charges partielles, et par un condensateur additionneur (CI1 à CI2), qui additionne les charges partielles,
que pour la formation d'une charge partielle, les condensateurs d'inversion de charge peuvent être raccordés respectivement par l'intermédiaire d'un dispositif de commutation commandable (S1 à S4), par une de leurs bornes, au condensateur additionneur (CI1 à CI2) ou à une première borne de la source de tension de référence (VREF1) et, par la borne restante, à une première ou à une seconde borne de la source de tension de référence,
que les dispositifs de commutation sont raccordés, pour leur commande, respectivement par l'intermédiaire d'un circuit combinatoire (V1 à V6 ou V1' à V6'), à des sorties fixées du générateur de signaux de commande, et
que le circuit combinatoire respectif commande le dispositif de commutation associé, lors de l'apparition d'un signal de commande sur les sorties, qui sont raccordées à ce circuit, du générateur de signaux de commande de sorte que le condensateur d'inversion de charge, raccordé à ce dispositif, délivre au condensateur additionneur ou reçoit de ce dernier une charge partielle, conformément à l'échelon, qui doit être formé lors de l'apparition du signal de commande respectif.

2. Dispositif de mise en forme d'impulsions suivant la revendication 1, caractérisé par le fait
que le générateur de signaux de commande est formé par un dispositif à registres à décalage (A,B) comportant une multiplicité de cellules de registre, qui correspond à la multiplicité des signaux de commande,
que le dispositif à registres à décalage reçoit l'information codée en binaire concernant les signaux numériques de sortie à plusieurs niveaux, devant être formés, et prélève de ces signaux respectivement un échantillon,
que l'échantillon respectif traverse succesivement les cellules des registres à une vitesse qui correspond aux intervalles de temps identiques présents entre les signaux de commande, et
que chaque apparition d'un échantillon dans les cellules des registres représente un signal de commande.

3. Dispositif de mise en forme d'impulsions pour la formation de signaux numériques de sortie à quatre niveaux, qui peuvent prendre deux premières valeurs symétriques par rapport à une valeur de référence, et deux secondes valeurs également symétriques par rapport à une valeur de référence et qui diffèrent des premières valeurs, d'un facteur entier fixé, suivant la revendication 1 ou 2, caractérisé par le fait
que lors de l'apparition d'un signal codé en binaire correspondant à un signal numérique de sortie possédant une première valeur, les condensateurs d'inversion de charge (C1 à C6 ou C1' à C6') délivrent seulement une fois une charge au condensateur additionneur (CI1 ou CI2) ou reçoivent seulement une fois une charge de ce condensateur, pour la formation d'une charge partielle respectivement pendant les intervalles de temps fixés pour cette dernière, alors que lors de l'apparition d'un signal codé en binaire, qui correspond à un signal numérique de sortie possédant une seconde valeur, les condensateurs d'inversion de charge délivrent une charge à plusieurs reprises au condensateur additionneur ou reçoivent à plusieurs reprises une charge de ce dernier, conformément au facteur fixé.

4. Dispositif de mise en forme d'impulsions suivant la revendication 3, caractérisé par le fait qu'au condensateur additionneur (CI1 ou CI2) est raccordé un interrupteur (SH ou SH'), qui peut être commandé par un circuit combinatoire particulier (S), qui est raccordé à des sorties fixées du générateur de signaux de commande (A,B) de telle sorte que le condensateur additionneur peut délivrer seulement à la fin de chaque intervalle de temps, le signal de sortie formé par ce condensateur jusqu'alors.

5. Dispositif de mise en forme d'impulsions pour la formation de signaux numériques de sortie à quatre niveaux, qui peuvent prendre deux premières valeurs symétriques par rapport à une valeur de référence, et deux secondes valeurs également symétriques par rapport à la valeur de référence et qui diffèrent des premières valeurs, d'un facteur entier fixé, suivant la revendication 1 ou 2, caractérisé par le fait que, lors de l'apparition d'un signal codé en binaire, qui correspond à un signal numérique de sortie possédant une seconde valeur, en parallèle avec les condensateurs d'inversion de charge (C1 à C6 ou C1' à C6') est branché respectivement un condensateur additionnel (C11, ..., C61 ou C11',...,C61'), dont la capacité est fixée de telle sorte que la combinaison respective de condensateurs, qui est constituée par un condensateur d'inversion de charge et un condensateur supplémentaire, délivre une charge, accrue d'une manière correspondant au facteur fixé, au condensateur additionneur (CI1 ou CI2) ou la reçoit de ce condensateur.

6. Dispositif de mise en forme d'impulsions suivant la revendication 5, caractérisé par le fait qu'en série avec chaque condensateur additionnel (C11, ..., C61 ou C11', ..., C61') est branché un interrupteur (S5 ou S5'), qui peut être commandé par le circuit combinatoire (V1, ..., V6 ou V1', ..., V6'), qui est associé au condensateur respectif d'inversion de charge, de telle sorte que le condensateur additionneur respectif est branché en parallèle avec le condensateur d'inversion de charge associé, uniquement lors de l'apparition de signaux codés en binaire qui correspondent à des signaux numériques de sortie possédant une seconde valeur.

**7.** Dispositif de mise en forme d'impulsions pour la formation de signaux numériques de sortie à quatre niveaux, qui peuvent prendre deux premières valeurs symétriques par rapport à une valeur de référence, et deux secondes valeurs également symétriques par rapport à la valeur de référence et qui diffèrent des premières valeurs, d'un facteur entier fixé, suivant la revendication 1 ou 2, caractérisé par le fait que les condensateurs d'inversion de charge (C1 à C6 ou C1' à C6') peuvent être raccordés à ladite source de tension de référence (VREF1), lors de l'apparition d'un signal codé en binaire correspondant à un signal numérique de sortie possédant une première valeur, et au contraire respectivement à une seconde source de tension de référence (VREF2), lors de l'apparition d'un signal codé en binaire qui correspond à un signal numérique de sortie possédant une seconde valeur, la tension de sortie de cette seconde source de tension de référence étant fixée de telle sorte que le condensateur d'inversion de charge respectif délivre une charge accrue en fonction du facteur fixé, au condensateur additionneur (CI1 ou CI2) ou la reçoit de ce condensateur.

**8.** Dispositif de mise en forme d'impulsions suivant la revendication 7, caractérisé par le fait que pour la sélection de la source de tension de référence, qui entre respectivement en jeu pour les condensateurs d'inversion de charge (C1 à C6 ou C1' à C6'), pour chacun des condensateurs d'inversion de charge il est prévu un autre dispositif de commutation (S6), qui peut être commandé à partir du circuit combinatoire (V1...V6 ou V1',... V6'), associé au condensateur d'inversion de charge respectif.

**9.** Dispositif de mise en forme d'impulsions suivant l'une des revendications 1 à 8, caractérisé par le fait qu'en parallèle avec le condensateur additionneur (CI1 ou CI2), il est prévu un autre interrupteur (SK ou SK'), qui peut être commandé par un autre circuit combinatoire (R), qui est raccordé à des sorties fixées du générateur de signaux de commande (A,B), de telle sorte qu'il court-circuite le condensateur additionneur (CI1 ou CI2) pendant des intervalles de temps fixé.

**10.** Dispositif de mise en forme d'impulsions suivant l'une des revendications 1 à 9, caractérisé par le fait que le réseau additionneur est prévu en double et que les deux condensateurs additionneurs (CI1 et CI2) sont raccordés respectivement à l'une des entrées et à une sortie, associée respectivement à cette entrée, d'un amplificateur opérationnel symétrique (GTV), et que la réception et la délivrance de charges partielles par les condensateurs d'inversion de charge sont permutées dans les deux réseaux additionneurs.

**11.** Dispositif de mise en forme d'impulsions suivant la revendication 10, caractérisé par le fait qu'une compensation d'offset est exécutée pour les amplificateurs opérationnels symétriques (GTV), dans les intervalles de temps, dans lesquels les condensateurs additionneurs (CI1 et CI2) sont court-circuités.

FIG 1
DIGITALTEIL MIT ECHO-KOMPENSATOR
IMPULS-FORMER
AUSGANGS TREIBER
ANALOGTEIL
GABEL
VER-MITTLUNGS-STELLE
ANALOG-DIGITAL UMSETZER
FIG 2
S1
C1
C6
S2
960kHz
S3
S4
VCC/2
VREF
SK
CI1
GTV
VS
CI2
SK'
V1
V6
SENDE
DATEN
A
B
2x14 BIT SCHIEBEREGISTER
R
V1'
V6'
C1',...,C6'
A
B
T
L
L
0
H
L
+1
L
H
-1

FIG 3a

FIG 3b

U
+1
+1
0
-1
+1
t
VS
+1
+1
2 4 6 8 10 12 14 16 18 20 22 ...
2 4 6 8 10 12 14
-1
+1
t

FIG 3c

C1
C2
C3
C4
C5
C6

FIG 4
C
3P
VCC
2
D
2P
R
Rp
E 3
E 4
GTV
E 1
E 2
CI2 = 3,12 P
CI1 = 3, 12P

FIG 6

S1
C1
C6
S2
1,92 MHz
S3
S4
VCC/2
VREF
SK
SH
VCC/2
CS1
CI1
GTV
VS
CI2
SH'
SK'
CS2
VCC/2
V1
V6
R
S
SENDE
DATEN
A
B
2x14 BIT
SCHIEBEREGISTER
V1'
V6'
C1',...,C6'

FIG 7

VS
+3
+1
-1
-3
Reset
1 2 3 4 5 6 7 8 10 11 12 13
t
+1
+3
-3
+1
+1
T = 1/80 KHz


FIG 8

C1
C2
C3
C4
C5
C6

FIG 9

S1
C1
C11
C6
C61
S5
S2
640kHz
SK
CI1
S3
S4
VCC/2
VREF
GTV
VS
CI2
V1
V6
SENDE
DATEN
A
B
2x14 BIT
SCHIEBEREGISTER
R
SK'
V1'
V6'
C1', C11', ..., C6', C61'

FIG 10
VS
+3
+1
-1
-3
t
1 2 3 4 5 6 7 8 9 10 11 12 13
+1
+3
-3
+1
+1
FIG 11
C1
C11 = 2C1
C2
C21 = 2C2
C3
C31 = 2C3
C4 = C3
C41 = 2C4
C5 = C2
C51 = 2C5
C6 = C1
C61 = 2C6

FIG 12

S1
C1
C6
S2
SK
640 kHz
CI1
S3
S4
VCC/2
GTV
VS
VREF1
S6
VREF2
CI2
V1
V6
SENDE
DATEN
A
B
2x14 BIT
SCHIEBEREGISTER
R
SK'
V1'
V6'
C1',...,C6'

FIG 13
VS
+3
+1
-1
-3
t
1 2 3 4 5 6 7 8 9 10 11 12 13
+1
+3
-3
+1
+1

FIG 14
C1
C2
C3
C4
C5
C6

FIG 15
P1
P1
P2
P2
VCC/2
(0V)
M7
M8
CI1
C1
GTV
M5
M6
P1
M3
M4
VCC/2
(0V)
M1
M2
VREF
(1,2V)
G3
G4
P1
G1
G2
V1
14
14
A
B
1
1